# EUROPÄISCHE PATENTSCHRIFT

(11) **EP 2 676 367 B1**
(45) Veröffentlichungstag und Bekanntmachung des Hinweises auf die Patenterteilung: **22.07.2015**
(21) Anmeldenummer: 12703554.1
(22) Anmeldetag: 14.02.2012
(51) Int. Cl.: H03K 3/037, H03K 5/00

(54) **SCHIEBEREGISTER UND EINER-AUS-VIELEN-SCHIEBEREGISTER**
SHIFT REGISTER AND ONE-FROM-MANY SHIFT REGISTER
REGISTRE À DÉCALAGE ET REGISTRE À DÉCALAGE COMPOSÉ DE PLUSIEURS REGISTRES À DÉCALAGES

(30) Priorität: 17.02.2011 DE 102011004310
(43) Veröffentlichungstag der Anmeldung: 25.12.2013
(73) Patentinhaber: Fraunhofer-Gesellschaft zur Förderung der angewandten Forschung e.V., 80686 München (DE)
(72) Erfinder: OBERST, Matthias, 90489 Nürnberg (DE); HAUER, Johann, 91058 Erlangen (DE)
(74) Vertreter: Burger, Markus
(86) Internationale Anmeldenummer: PCT/EP2012/052509
(87) Internationale Veröffentlichungsnummer: WO 2012/110509

(56) Entgegenhaltungen:
- US-A1- 2005 229 059

## Beschreibung

### Technisches Gebiet

Ausführungsbeispiele der vorliegenden Erfindung schaffen ein Schieberegister, wie es beispielsweise in Einer-aus-Vielen-Schieberegistern verwendet werden kann. Weitere Ausführungsbeispiele schaffen ein Einer-Aus-Vielen-Schieberegister, wie es beispielsweise in Bildsensoren, oder allgemein in Multiplexern verwendet werden kann.

### Hintergrund der Erfindung

Bei einer Einer-Aus-Vielen-Auswahlschaltung besitzt aus einer Anzahl N von Ausgängen genau ein Ausgang einen Digitalpegel von "1". Alle anderen Ausgänge haben einen Pegel von "0". Für die Realisierung wird ein Schieberegister verwendet, durch das eine "1" geschoben wird.

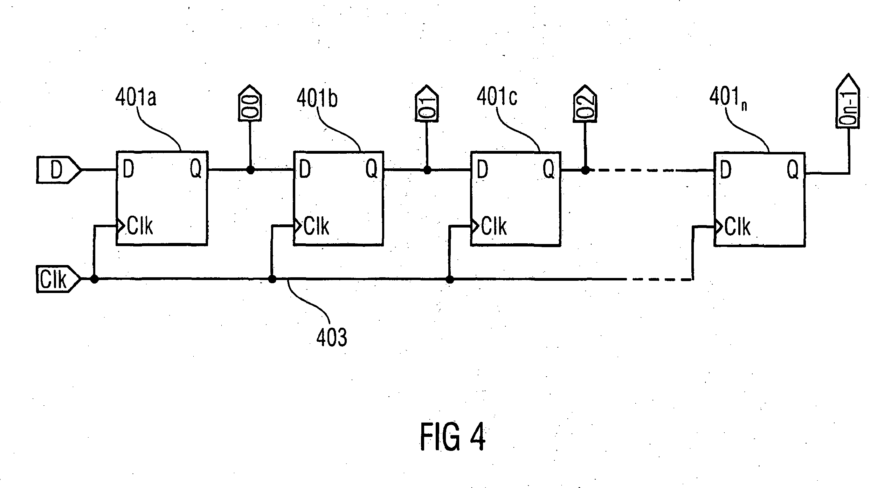

Der Aufbau eines solchen konventionellen Schieberegisters (SR) ist in Fig. 4 gezeigt.

Die Flip-Flops 401a bis 401n werden so aneinander angeschlossen, dass alle D-Flip-Flops 401a bis 401n dasselbe Taktsignal 403 (oder zumindest dieselben Taktpegel und Taktflanken) erhalten. Der Ausgang des einen D-Flip-Flops wird an den Eingang des nächsten D-Flip-Flops angeschlossen.

Ein weiteres Beispiel ist im US 2005/022 9059 A1 offenbart.

Die in Fig. 4 gezeigten D-Flip-Flops können dabei wie in Fig. 5 gezeigt aufgebaut sein.

In Fig. 5 sind zusätzlich zwei Inverter 501, 503 für die Taktinvertierung und Taktaufbereitung eingefügt, die in vielen Standardzellen enthalten sind.

Der Inverter 501 am Eingang des D-Flip-Flops 401a ist für das Auffrischen eines Eingangssignals 505 zuständig und der Inverter 503 am Ausgang des D-Flip-Flops 401a ist für das Treiben der Ausgangslast zuständig. Dazwischen befinden sich zwei Latches 507, 509 (Latch-Speicherglied), die eine zueinander invertierte Taktansteuerung besitzen.

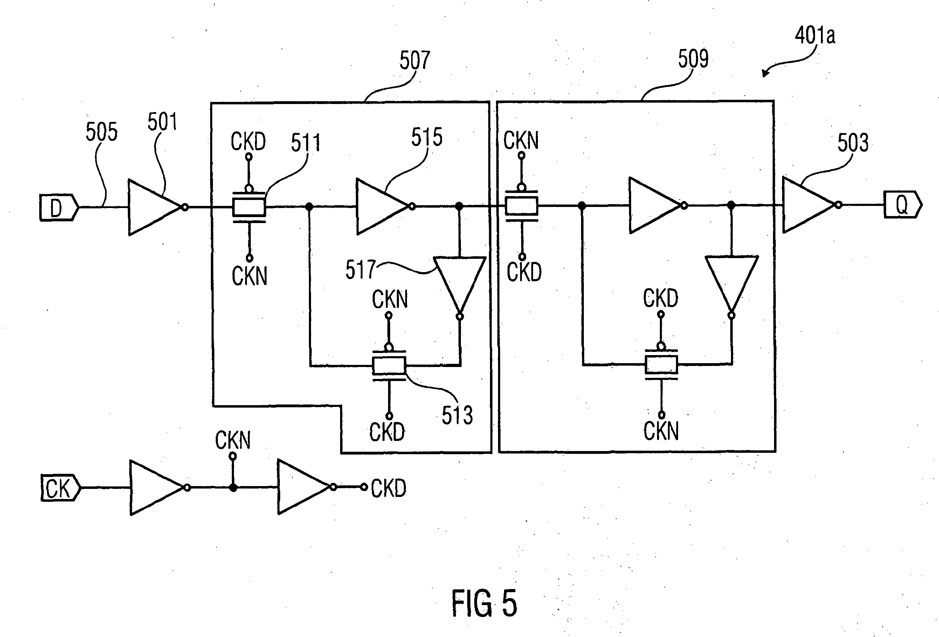

Ein erstes Latch 507 übernimmt die Daten am Eingang, wenn ein Eingangsschalter 511 des ersten Latchs 507 geschlossen (leitend) ist. In Fig. 5 übernimmt das erste Latch 507 die Eingangsdaten, wenn CKD "0" und CKN "1" ist, d. h. bei CK = "0" (bei einem niedrigen Pegel des Taktsignals 403). Ein Rückkoppelschalter 513 des ersten Latchs 507 ist dann geöffnet (nicht leitend) und Inverter 515, 517 des ersten Latchs 507 nehmen einen Zustand an, der vom Eingangssignal 505 abhängt. Während CK = "0" ist, bewirkt jede Änderung des Eingangssignals 505 eine Änderung der Inverterausgänge der beiden Inverter 515, 517 des ersten Latchs 507. Man sagt, das Latch ist transparent. Bei der steigenden Flanke von CK (des Taktsignals 403) öffnet der Eingangsschalter 511 des ersten Latchs 507 und der Rückkoppelschalter 513 des ersten Latchs 507 schließt. Dabei wird der vorherige Eingangswert in den rückgekoppelten Invertern 515, 517 gespeichert. Das erste Latch 507 ist nun nicht mehr transparent.

Durch die Serienschaltung der invertiert getakteten Latches 507, 509 ist immer ein Latch transparent, während das andere Latch sperrt. Während CK = "0" ist, wird der Eingang (der Signalzustand des Eingangssignals 505 an dem Eingang) in dem ersten Latch 507 transparent übernommen. Das zweite Latch 509 hält währenddessen den alten Ausgangswert. Steigt CK auf "1", speichert das erste Latch 507 den vorherigen Eingangswert und gibt ihn an das zweite Latch 509 weiter. Das zweite Latch 509 ist nun transparent, der Ausgang ändert sich jedoch nicht, weil sich der Eingang nicht ändert (da das erste Latch 507 in dem nichttransparenten Zustand ist). Der Eingang wird zum Ausgang weitergeleitet. Damit übernimmt das D-Flip-Flop 401a den Eingang bei steigender Taktflanke auf den Ausgang. Zwischen den Taktflanken kann sich das Eingangssignal 505 ändern, ohne dass sich der Ausgang ändert.

In dem in Fig. 4 gezeigten Schieberegister wird im Ausgangszustand angenommen, dass alle D-Flip-Flops 401 a bis 401n "0" am Ein- und Ausgang haben und der Taktpegel bei "0" liegt. Wird nun eine "1" an den Eingang des Schieberegisters gelegt (an einem Dateneingang des ersten D-Flip-Flops 401a) und am Takt eine steigende Flanke angelegt, wird diese "1" in das erste D-Flip-Flop 401a übernommen, alle anderen D-Flip-Flops 401b bis 401n übernehmen die Eingänge zu den Ausgängen, laut Anfangswert "0". Danach wird eine "0" an den Eingang des Schieberegisters gelegt und eine weitere Taktperiode erzeugt. Die "0" am Eingang wird in das erste D-Flip-Flop 401 a übernommen, während das zweite D-Flip-Flop 401b die "1" vom ersten D-Flip-Flop 401a übernimmt. Alle anderen D-Flip-Flops übernehmen wieder "0". Bei jeder weiteren steigenden Taktflanke (des Taktsignals 402) wird die "1" ein D-Flip-Flop weiter geschoben.

Diese Schaltung kann nun benutzt werden, um aus N eines auszuwählen. Dafür braucht man N DFFs.

Die Anzahl der Transistoren, die benötigt werden, um die Funktion zu implementieren, sind N * 24, da ein DFF 24 Transistoren enthält. Vorausgesetzt wird dabei, dass ein Schalter und ein Inverter jeweils aus zwei Transistoren aufgebaut sind.

Es gibt noch die Möglichkeit, dynamische DFFs zu verwenden. Diese haben jedoch den Nachteil, dass sie nur ab einer Mindesttaktfrequenz fehlerfrei arbeiten. Für jeden Ausgang des Schieberegisters ist damit ein D-Flip-Flop notwendig. Aufgrund dessen, dass herkömmliche D-Flip-Flop-Implementierungen (wie sie beispielsweise in Fig. 5 gezeigt ist) 24 Transistoren benötigen, wird für ein solches Schieberegister eine große Anzahl an Transistoren und damit eine große Fläche für das Schieberegister benötigt.

### Zusammenfassung der Erfindung

Es ist eine Aufgabe der vorliegenden Erfindung, ein Konzept zu schaffen, welches ein flächeneffizienteres Schieberegister ermöglicht.

Diese Aufgabe wird gelöst durch ein Schieberegister gemäß Anspruch 1.

Ausführungsbeispiele der vorliegenden Erfindung schaffen ein Schieberegister mit einem ersten Latch, einem zweiten Latch, einer ersten Ausgangsschaltung und einer zweiten Ausgangsschaltung.

Das erste Latch ist ausgelegt, um in einem transparenten Betriebszustand einen an seinem Eingang anliegenden Signalzustand zu übernehmen und um in einem nichttransparenten Betriebszustand den übernommenen Signalzustand aufrechtzuerhalten. Das zweite Latch ist ausgelegt, um in einem transparenten Betriebszustand einen an seinem Eingang anliegenden Signalzustand zu übernehmen und um in einem nichttransparenten Betriebszustand den übernommenen Signalzustand aufrechtzuerhalten.

Das erste Latch und das zweite Latch sind in Serie geschaltet. Ein Eingangspegel an dem zweiten Latch kann daher auf einem Ausgangspegel an dem ersten Latch basieren.

Takteingänge der beiden Latches sind so geschaltet, dass das zweite Latch in dem transparenten Betriebszustand ist, wenn das erste Latch in dem nichttransparenten Betriebszustand ist, und dass das erste Latch in dem transparenten Betriebszustand ist, wenn das zweite Latch in dem nichttransparenten Betriebszustand ist. Beispielsweise können die Takteingänge der beiden Latches invertiert zueinander angesteuert werden.

Die erste Ausgangsschaltung ist ausgelegt, um an einem ersten Schieberegisterausgang des Schieberegisters in dem transparenten Betriebszustand des ersten Latches einen vorgegebenen, von dem in dem ersten Latch vorhandenen Signalzustand unabhängiges Pegel bereitzustellen, und in dem nichttransparenten Betriebszustand des ersten Latches einen, von dem in dem ersten Latch gespeicherten Signalzustand abhängigen Pegel (beispielsweise identisch zu dem in dem ersten Latch gespeicherten Signalzustand oder invertiert zu diesem) bereitzustellen.

Die zweite Ausgangsschaltung ist ausgelegt, um an einem zweiten Schieberegisterausgang des Schieberegisters in dem transparenten Betriebszustand des zweiten Latches einen vorgegebenen, von dem in dem zweiten Latch vorhandenen Signalzustand unabhängigen Pegel bereitzustellen, und in den nichttransparenten Betriebszustand des zweiten Latches einen, von dem in dem zweiten Latch gespeicherten Signalzustand abhängigen Pegel (beispielsweise identisch zu dem in dem zweiten Latch gespeicherten Signalzustand oder invertiert zu diesem) bereitzustellen.

Es ist ein Kerngedanke der vorliegenden Erfindung, dass ein flächeneffizienteres Schieberegister (welches beispielsweise eine geringere Anzahl von Transistoren benötigt) geschaffen werden kann, wenn die typischen in einem D-Flip-Flop verwendeten Latches benutzt werden um zwei "aufeinander folgende" bzw. benachbarte (im Sinne einer Verschiebung des Eingangswertes) Schieberegisterausgänge anzusteuern. Es wurde herausgefunden, dass ein taktflankengesteuertes Verhalten des Schieberegisters erreicht werden kann, wenn der Pegel an dem ersten Schieberegisterausgang nur in dem nichttransparenten Betriebsmodus des ersten Latches von dem in dem ersten Latch gespeicherten Signalzustand abhängig ist und in dem transparenten Betriebsmodus des ersten Latches ein vorgegebener Pegel an dem ersten Schieberegisterausgang anliegt. Dadurch kann, wie bei einem D-Flip-Flop, erreicht werden, dass sich der Ausgang nicht ändert, obwohl sich der Eingang ändert. Dies gilt analog für den zweiten Schieberegisterausgang und das zweite Latch. Aufgrund der Beschaltung der Takteingänge der beiden Latches so, dass, wenn das erste Latch in dem nichttransparenten Betriebsmodus ist, das zweite Latch in dem transparenten Betriebsmodus ist und umgekehrt, und auf Grund der entsprechend gesteuerten Ausgangsschaltungen wird erreicht, dass immer (abgesehen von Umschaltzeitpunkten) einer der Schieberegisterausgänge einen Pegel hat, der von einem in seinem zugehörigen Latch gespeicherten Signalzustand abhängig ist, während der andere Schieberegisterausgang einen festen vorgegebenen Pegel hat.

Des Weiteren wurde herausgefunden, dass durch die Nutzung der beiden (taktmäßig invertiert zueinander angesteuerten) in Serie verschalteten Latches erreicht werden kann, dass der Ausgang bzw. ein auszugebender Wert bei jeder Taktflanke (also bei fallender und steigender Taktflanke) von einem Schieberegisterausgang zu einem nächsten Schieberegisterausgang weiter geschoben wird (und nicht wie bei dem in Fig. 4 gezeigten konventionellen Schieberegister nur bei jeder zweiten Taktflanke).

In anderen Worten, bei dem erfindungsgemäßen Schieberegister gibt es zumindest einen Ausgang pro Latch, wobei entsprechende Ausgangsschaltungen vorgesehen sind. Somit erscheint ein Eingangswert (zum Beispiel eine "1", der zumindest eine "0" vorausgeht und zumindest eine "0" folgt) innerhalb einer Periode des Taktsignals an zwei Schieberegisterausgängen, nämlich beispielsweise in einer erste Phase des Taktsignals (z.B. "1" - Zustand des Taktsignals) an dem ersten Schieberegisterausgang und in einer zweiten Phase des Taktsignals (z.B. "0" - Zustand des Taktsignals) an dem zweiten Schieberegisterausgang.

Dadurch lässt sich erreichen, dass die Taktfrequenz zur Ansteuerung des Schieberegisters halbiert werden kann, aber eine an dem Eingang des Schieberegisters (an dem Eingang des ersten Latches) anliegende "1" genauso schnell weiter geschoben wird, wie bei dem in Fig. 4 gezeigten konventionellen Schieberegister.

Es ist ein Vorteil von Ausführungsbeispielen der vorliegenden Erfindung, dass ein Schieberegister mit deutlich reduziertem Schaltungsaufwand geschaffen werden kann, welches zusätzlich eine Halbierung der Taktfrequenz ermöglicht, ohne eine Schiebegeschwindigkeit zu reduzieren. Durch die mögliche Reduzierung der Taktfrequenz können Störungen anderer Schaltungsteile auf demselben integrierten Schaltkreis reduziert werden und außerdem kann der Stromverbrauch des Schieberegisters, gegenüber konventionellen Schieberegistern, gesenkt werden. Das Schieberegister eignet sich gut für Folgen von logischen Werten, bei denen isolierte "1"-Werte bzw. isolierte "0"-Werte auftreten.

Ausführungsbeispiele ermöglichen dadurch ein flächeneffizienteres und stromeffizienteres Schieberegister.

Gemäß Ausführungsbeispielen können die Takteingänge der beiden Latches invertiert geschaltet sein, derart, dass wenn an dem Takteingang des ersten Latches ein erster Pegel anliegt (beispielsweise ein digitaler High-Pegel (Hoch-Pegel) oder eine logische "1"), an dem Takteingang des zweiten Latches ein zu dem ersten Pegel komplementärer Pegel (beispielsweise ein digitaler Low-Pegel (Niedrig-Pegel) oder eine logische "0") anliegt. So kann beispielsweise der Takteingang des ersten Latches mit einem Takteingang des Schieberegisters derart gekoppelt sein, dass der Pegel am Takteingang des ersten Latches gleich dem Pegel am Takteingang des Schieberegisters ist und der Takteingang des zweiten Latches kann so mit dem Takteingang des Schieberegisters gekoppelt sein, so dass der Pegel am Takteingang des zweiten Latches invertiert zu dem Pegel am Takteingang des Schieberegisters ist. Die beiden Latches können beispielsweise taktzustandsgesteuerte Latches sein, d. h. sie befinden sich in Abhängigkeit von dem Pegel des an ihrem Takteingang anliegenden Taktsignals entweder in dem transparenten Betriebsmodus oder dem nichttransparenten Betriebsmodus. Beispielsweise kann ein High-Pegel oder eine "1" an dem Takteingang der Latches dazu führen, dass sich die Latches in ihrem nichttransparenten Betriebszustand befinden und ein Low-Pegel oder eine "0" kann dazu führen, dass sich die Latches in ihrem transparenten Betriebszustand befinden oder umgekehrt. Die beiden Latches können daher eine identische interne Taktsteuerung zum Ansteuern der Betriebszustände der Latches aufweisen.

In der vorliegenden Anmeldung wird unter einer Kopplung zweier Anschlüsse eine direkte Kopplung und eine indirekte Kopplung mit einem oder mehreren dazwischen geschalteten Bauelementen verstanden, so dass ein Signal an einem zweiten Schaltungsknoten (oder an einem zweiten Anschluss) von einem Signal an einem ersten Schaltungsknoten (oder an einem ersten Anschluss), der mit dem zweiten Schaltungsknoten gekoppelt ist, abhängig ist. Mit anderen Worten können zwischen den zwei miteinander gekoppelten Anschlüssen weitere Bauelemente, insbesondere passive Bauelemente, wie beispielsweise Widerstände oder Schaltstrecken aktiver Bauelemente, wie beispielsweise von Schaltern oder Transistoren oder auch Inverter geschaltet sein. Bei miteinander gekoppelten Anschlüssen kann ein Bauteil zwischen diese Anschlüsse geschaltet sein, muss aber nicht, so dass zwei miteinander gekoppelte Anschlüsse auch direkt (d. h. durch eine niederohmige leitende Verbindung) miteinander verbunden sein können.

Weiterhin ist gemäß der vorliegenden Anmeldung ein erster Anschluss mit einem zweiten Anschluss direkt verbunden, wenn ein an den zweiten Anschluss anliegendes Signal identisch einem an dem ersten Anschluss anliegenden Signal ist, wobei parasitäre Effekte oder geringfügige Verluste aufgrund von Leiterwiderständen oder Verzögerungen aufgrund zusätzlicher Pufferelemente außer Betracht bleiben sollen. Zwei direkt miteinander verbundene Anschlüsse sind daher typischerweise über Leiterbahnen oder Drähte verbunden ohne zusätzliche dazwischen geschaltete Bauteile.

Gemäß weiteren Ausführungsbeispielen kann aber auch dasselbe Taktsignal an dem ersten Latch und dem zweiten Latch anliegen, wobei jedoch die interne Taktsteuerung der Latches verschieden ist, so dass beispielsweise ein High-Pegel an dem Takteingang des ersten Latches dazu führt, dass sich das erste Latch in dem nichttransparenten Betriebszustand befindet, während ein High-Pegel an dem Takteingang des zweiten Latches dazu führt, dass sich das zweite Latch in dem transparenten Betriebszustand befindet. Ein Low-Pegel an dem Takteingang des ersten Latches führt dann dazu, dass sich das erste Latch in dem transparenten Betriebszustand befindet und ein Low-Pegel an dem Takteingang des zweiten Latches führt dazu, dass sich das zweite Latch in dem nichttransparenten Betriebszustand befindet oder umgekehrt.

Gemäß weiteren Ausführungsbeispielen können auch die Ausgangsschaltungen Takteingänge aufweisen, wobei die Takteingänge der Ausgangsschaltungen invertiert geschaltet sein können, derart, dass wenn an dem Takteingang der ersten Ausgangsschaltung ein erster Pegel anliegt, ein zu dem ersten Pegel komplementärer Pegel an dem Takteingang der zweiten Ausgangsschaltung anliegt.

### Kurzbeschreibung der Figuren

Ausführungsbeispiele der vorliegenden Erfindung werden im Folgenden anhand der beiliegenden Figuren detailliert beschrieben. Es zeigen:

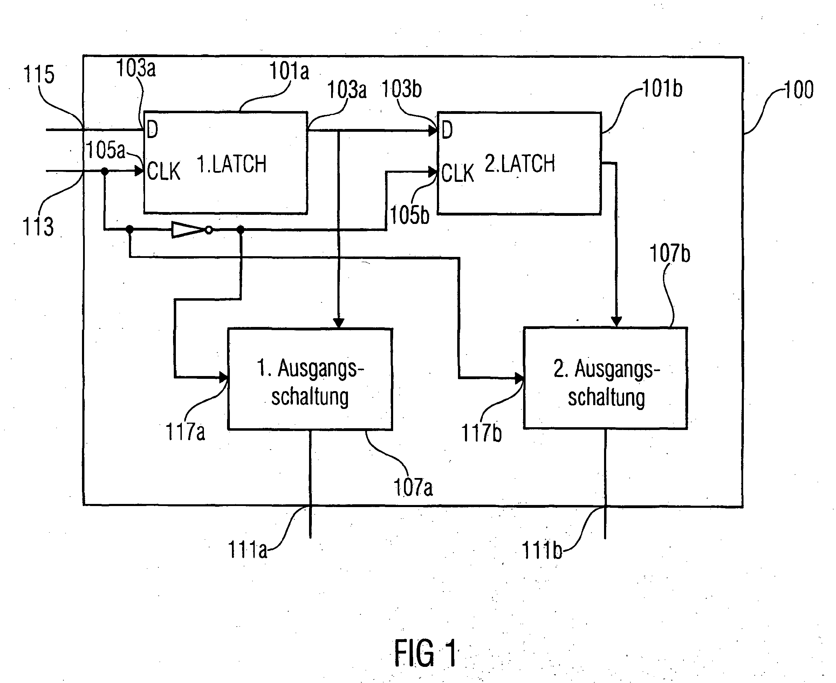

- Fig. 1: ein Blockschaltbild eines Schieberegisters gemäß einem Ausführungsbeispiel;

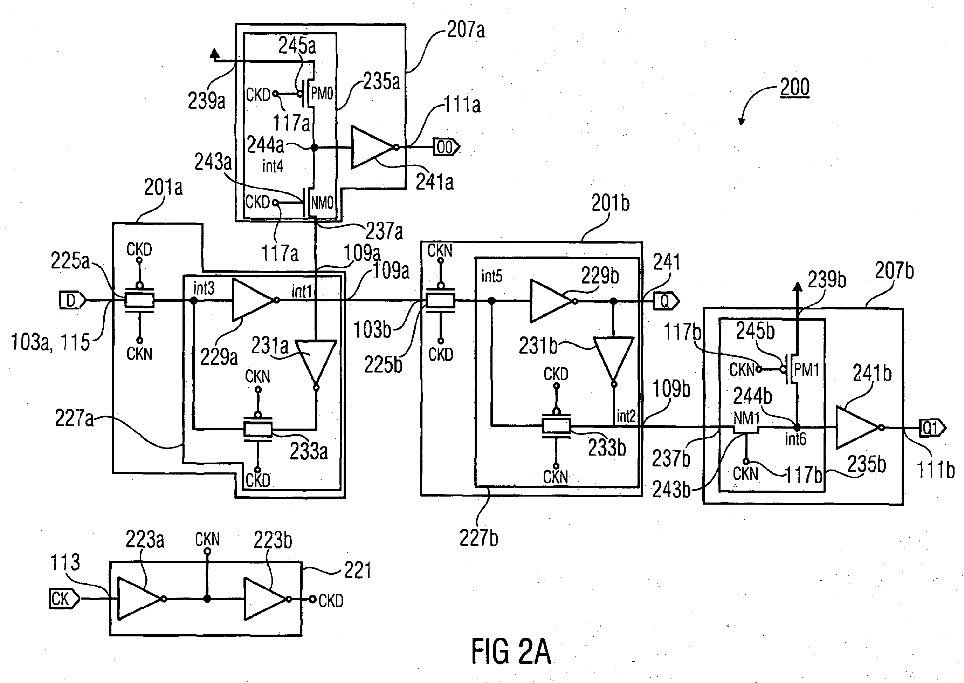

- Fig. 2a: eine schematische Darstellung einer Schaltung eines Schieberegisters gemäß einem weiteren Ausfiihrungsbeispiel;

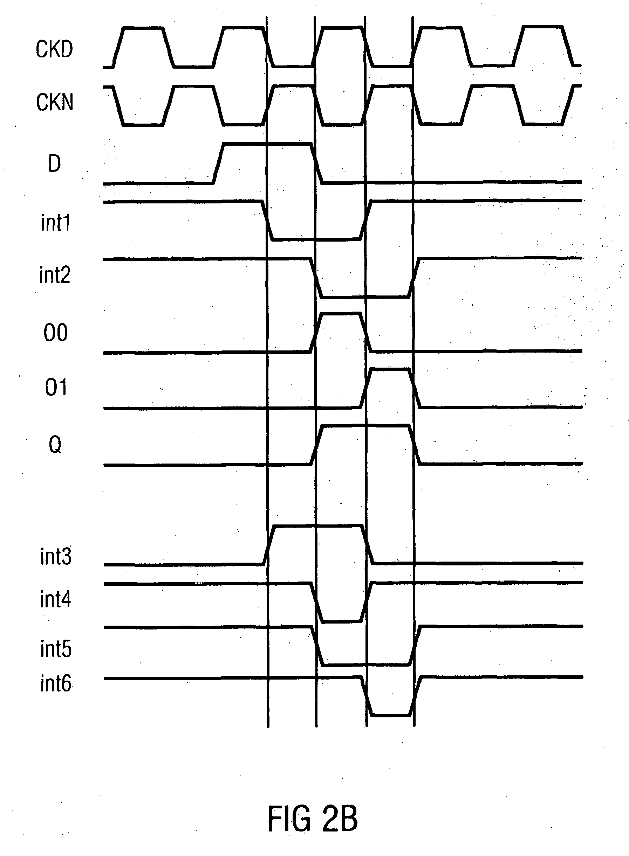

- Fig. 2b: ein Zeitzustandsdiagramm von Zuständen verschiedener Signalknoten des in Fig. 2a gezeigten Schieberegisters;

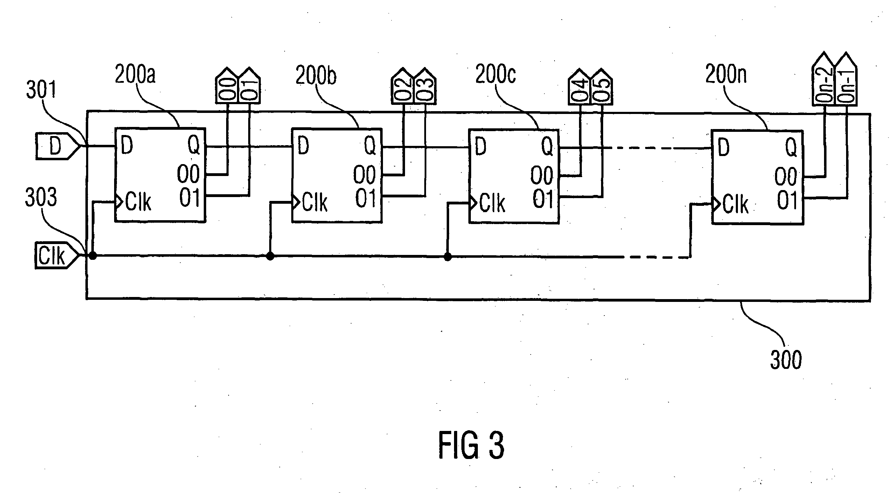

- Fig. 3: ein Blockschaltbild eines Einer-Aus-Vielen-Schieberegister gemäß einem Ausführungsbeispiel;
- Fig. 4: ein Blockschaltbild eines konventionellen Schieberegisters; und
- Fig. 5: eine schematische Darstellung einer Schaltung eines D-Flip-Flops.

Bevor im Folgenden Ausführungsbeispiele der vorliegenden Erfindung detailliert beschrieben werden, wird darauf hingewiesen, dass gleiche Elemente oder Elemente gleicher Funktion mit denselben Bezugszeichen versehen sind und dass auf eine wiederholte Beschreibung dieser Elemente verzichtet wird. Beschreibungen von Elementen mit demselben Bezugszeichen sind daher untereinander austauschbar.

Fig. 1 zeigt ein Blockschaltbild eines Schieberegisters 100 gemäß einem Ausführungsbeispiel.

Das Schieberegister 100 weist ein erstes Latch 101a mit einem Dateneingang 103a und einem Takteingang 105a auf. Weiterhin weist das Schieberegister 100 ein zweites Latch 101b mit einem Dateneingang 103b und einem Takteingang 105b auf. Weiterhin weist das Schieberegister 100 eine erste Ausgangsschaltung 107a und eine zweite Ausgangsschaltung 107b auf.

Das erste Latch 101a ist ausgelegt, um in einem transparenten Betriebszustand einen an seinem Dateneingang 103a anliegenden Signalzustand zu übernehmen und um in einem nichttransparenten Betriebszustand den übernommenen Signalzustand aufrechtzuerhalten.

Das zweite Latch 101b ist ausgelegt, um in einem transparenten Betriebszustand einen an seinem Dateneingang 103b anliegenden Signalzustand zu übernehmen und um in einem nichttransparenten Betriebszustand den übernommenen Signalzustand aufrechtzuerhalten.

Das erste Latch 101a und das zweite Latch 101b sind in Serie geschaltet, beispielsweise so, dass ein Pegel an dem Dateneingang 103b des zweiten Latches 101b auf einen Pegel an einem Ausgang 109a des ersten Latches 101a basiert.

Die Takteingänge 105a, 105b der Latches 101a, 101b sind so geschaltet, dass das zweite Latch 101b in dem transparenten Betriebszustand ist, wenn das erste Latch 101a in dem nichttransparenten Betriebszustand ist und umgekehrt, also, das zweite Latch 101b in dem nichttransparenten Betriebszustand ist, wenn das erste Latch 101a in dem transparenten Betriebszustand ist.

Die erste Ausgangsschaltung 107a ist ausgelegt, um an einem ersten Schieberegisterausgang 111a des Schieberegisters 100 in dem transparenten Zustand des ersten Latches 101a einen vorgegebenen, von dem in dem ersten Latch 101a vorhandenen Signalzustand unabhängigen Pegel bereitzustellen, und in dem nichttransparenten Betriebszustand des ersten Latches 101a einen, von dem in dem ersten Latch 101a gespeicherten Signalzustand abhängigen Pegel bereitzustellen.

Die zweite Ausgangsschaltung 107b ist ausgelegt, um an einem zweiten Schieberegisterausgang 111b des Schieberegisters 100 in dem transparenten Betriebszustand des zweiten Latches 101b einen vorgegebenen, von dem in dem zweiten Latch 101b vorhandenen Signalzustand unabhängigen Pegel bereitzustellen, und in dem nichttransparenten Betriebszustand des zweiten Latches 101b einen, von dem in dem zweiten Latch 101b gespeicherten Signalzustand abhängigen Pegel bereitzustellen.

Der Takteingang 105a des ersten Latches 101a kann gekoppelt (beispielsweise direkt verbunden oder mittels zweier in Serie geschalteter Inverter) mit einem Takteingang 113. des Schieberegisters 100 sein, beispielsweise derart, dass ein Pegel an dem Takteingang 105a des ersten Latches 101a gleich einem Pegel an dem Takteingang 113 des Schieberegisters 100 ist.

Der Takteingang 105b des zweiten Latches 101b kann gekoppelt (beispielsweise mittels eines Inverters) mit einem Takteingang 113 des Schieberegisters 100 sein, beispielsweise derart, dass ein Pegel an dem Takteingang 105b des zweiten Latches 101 b komplementär zu einem Pegel an dem Takteingang 113 des Schieberegisters 100 (und zu dem Pegel an dem Takteingang 105a des ersten Latches 101a) ist.

Weiterhin kann der Dateneingang 103 a mit einem Dateneingang 115 des Schieberegisters 100 gekoppelt (beispielsweise direkt verbunden) sein, beispielsweise derart, dass ein Pegel an dem Dateneingang 103a des ersten Latches 101a einem Pegel an dem Dateneingang 115 des Schieberegisters 100 ist.

Im Folgenden soll die Funktionsweise des in Fig. 1 gezeigten Schieberegisters 100 erläutert werden. Es wird dabei angenommen, dass sich die Latches 101a und 101b bei einem Low-Pegel an ihren Takteingängen 105a, 105b in dem nichttransparenten Betriebszustand befinden und bei einem High-Pegel an ihren Takteingängen 105a, 105b in dem transparenten Betriebszustand befinden.

Ausgehend von einem Zustand, in dem ein Pegel des in dem ersten Latch 101a vorhandenen Signalzustands "0" ist und ein Pegel des in dem zweiten Latch 101b vorhandenen Signalzustands "0" ist, wird an dem Dateneingang 115 des Schieberegisters 100 eine "1" angelegt. Diese "1" wird bei dem nächsten transparenten Betriebszustand des ersten Latches 101a (also bei dem nächsten "0"-Pegel an dem Takteingang 105a des ersten Latches 101a) in das erste Latch 101a übernommen. In dem transparenten Zustand des ersten Latches 101a stellt die erste Ausgangsschaltung 107a an dem ersten Schieberegisterausgang 111a einen vorgegebenen Pegel bereit (beispielsweise "0"-Pegel). Weiterhin befindet sich das zweite Latch 101b in dem nichttransparenten Zustand, so dass die zweite Ausgangsschaltung 107b an dem zweiten Schieberegisterausgang 111b einen Pegel in Abhängigkeit von dem in dem zweiten Latch 101b gespeicherten Signalzustand bereitstellt (beispielsweise "0"-Pegel, da der in dem zweiten Latch 101b gespeicherte Signalzustand "0"-Pegel hat).

Bei dem nächsten "1"-Pegel am Takteingang 113 des Schieberegisters 100 schaltet das erste Latch 101a in den nichttransparenten Betriebsmodus und erhält den übernommenen Signalzustand (die von dem Dateneingang 103a übernommene "1") aufrecht. Weiterhin stellt die erste Ausgangsschaltung 107a an dem ersten Schieberegisterausgang 111a einen Pegel in Abhängigkeit von dem in dem ersten Latch 101a gespeicherten Signalzustand bereit (beispielsweise "1"-Pegel, da der in dem ersten Latch 101a gespeicherte Signalzustand "1"-Pegel hat). Weiterhin schaltet das zweite Latch 101b in den transparenten Zustand und übernimmt den an seinem Dateneingang 103b anliegenden Signalzustand (welcher aufgrund der Serienschaltung der beiden Latches 101a, 101b auf dem Signalzustand in dem ersten Latch 101a basiert und beispielsweise identisch zu diesem ist, also beispielsweise "1"-Pegel hat). Weiterhin stellt die zweite Ausgangsschaltung 107b an dem zweiten Schieberegisterausgang 111b den vorgegebenen Pegel (beispielsweise "0"-Pegel) bereit.

Bei Schieberegistern ist der "1"-Pegel an dem Dateneingang 115 typischerweise nur für einen Taktzyklus (beispielsweise von einer steigenden Flanke bis zur nächsten steigenden Flanke) verfügbar. Das heißt, bei dem nächsten "0"-Pegel des Taktsignals am Taktsignaleingang 113 des Schieberegisters 100 ist der Dateneingang 115 bereits zurückgesetzt (auf "0"-Pegel). Das zweite Latch 101b schaltet in den nichttransparenten Betriebszustand und erhält den von seinem Dateneingang 103b übernommenen Signalzustand (also den "1" Pegel) aufrecht. Die zweite Ausgangsschaltung 107b stellt an dem zweiten Schieberegisterausgang 111b einen Pegel in Abhängigkeit des in dem zweiten Latch 101b gespeicherten Signalzustands bereit (beispielsweise den "1"-Pegel, da der in dem zweiten Latch 101b gespeicherte Signalzustand "1"-Pegel hat).

Weiterhin schaltet das erste Latch 101a in den transparenten Betriebszustand und übernimmt den an seinem Dateneingang 103a anliegenden Signalzustand. Die erste Ausgangsschaltung 107a stellt an dem ersten Schieberegisterausgang 111a den vorgegebenen Pegel, welcher unabhängig von dem Signalzustand in dem ersten Latch 101a ist, bereit.

Durch das in Fig. 1 gezeigte Konzept wird ein taktflankengesteuertes Schieberegister ermöglicht, welches in einem Taktzyklus (oder einer Taktperiode an dem Takteingang 113) eine "1" an seinem Dateneingang 115 zweimal weiter schiebt.

Bei einem konventionellen Schieberegister müssten, um die in Fig. 1 gezeigte Funktionalität zu erreichen, zwei D-Flip-Flops (mit jeweils zwei Latches) verwendet werden und diese müssten doppelt so schnell getaktet sein wie dies bei dem in Fig. 1 gezeigten Konzept der Fall ist. Ausführungsbeispiele der vorliegenden Erfindung ermöglichen daher ein flächeneffizienteres sowie stromeffizienteres Schieberegister.

Wie in Fig. 1 gezeigt, kann weiterhin die Ausgangsschaltung 107a einen Takteingang 117a aufweisen und die zweite Ausgangsschaltung 107b kann einen Takteingang 117b aufweisen. Die Takteingänge 117a, 117b der Ausgangsschaltungen 107a, 107b können invertiert geschaltet sein, derart, dass wenn an dem Takteingang 117a der ersten Ausgangsschaltung 107a ein erster Pegel anliegt (beispielsweise ein "1"-Pegel) an dem Takteingang 117b der zweiten Ausgangsschaltung 107b ein zu dem Pegel an dem Takteingang 117a komplementärer Pegel (beispielsweise ein "0"-Pegel) anliegt. Wie weiterhin in Fig. 1 gezeigt, können die Ausgangsschaltungen 107a, 107b dasselbe Taktsignal von dem Takteingang 113 des Schieberegisters 100 empfangen, wie die beiden Latches 101a, 101b. So kann erreicht werden, dass bei einer Umschaltung der Betriebszustände der Latches 101a, 101b auch Schaltzustände der Ausgangsschaltungen 107a, 107b gleichzeitig umgeschaltet werden.

Mit anderen Worten kann der Takteingang 113 des Schieberegisters 100 mit den Takteingängen 105a, 105b der beiden Latches 101a, 101b und mit den Takteingängen 117a, 117b der Ausgangsschaltungen 107a, 107b gekoppelt sein, derart, dass ansprechend auf einen Taktzustandswechsel an dem Takteingang 113 des Schieberegisters 100 sowohl die Betriebszustände der Latches 101a, 101b als auch die Schaltzustände der Ausgangsschaltungen 107a, 107b wechseln. Beispielsweise können die Ausgangsschaltungen 107a, 107b in einem ersten Schaltzustand an ihrem zugeordneten Schieberegisterausgang den Pegel in Abhängigkeit von dem in dem zugeordneten Latch gespeicherten Signalwert bereitstellen und in einem zweiten Schaltzustand den vorgegebenen Pegel bereitstellen.

Die erste Ausgangsschaltung 107a hat daher ihren ersten Schaltzustand, wenn das erste Latch 101a in dem nichttransparenten Betriebszustand ist und den zweiten Schaltzustand, wenn das erste Latch 101a in dem transparenten Betriebszustand ist. Dies gilt analog für die zweite Ausgangsschaltung 107b und das zweite Latch 101b.

Fig. 2a zeigt eine schematische Darstellung einer Schaltung eines Schieberegisters 200 gemäß einem weiteren Ausführungsbeispiel. Das Schieberegister 200 kann eine mögliche Implementierung des in Fig. 1 gezeigten Schieberegisters 100 sein. Das Schieberegister 200 weist ein erstes Latch 201 a und ein zweites Latch 201 b auf. Die beiden Latches 201a, 201b können in ihrer Funktionalität den beiden Latches 101a, 101b des Schieberegisters 100 entsprechen. Weiterhin weist das Schieberegister 200 eine erste Ausgangsschaltung 207a und eine zweite Ausgangsschaltung 207b auf. Die beiden Ausgangsschaltungen 207a, 207b können in ihrer Funktionalität den beiden Ausgangsschaltungen 107a, 107b des Schieberegisters 100 entsprechen.

Weiterhin weist das Schieberegister 200 einen optionalen Taktsignalinverter und Taktsignalauffrischer 221 auf.

Der Taktsignalinverter und Taktsignalauffrischer 221 ist ausgebildet, um ein Taktsignal CK an dem Taktsignaleingang 115 des Schieberegisters 200 zu invertieren und aufzufrischen, um das Taktsignal CK in einer invertierten Version CKN und einer nichtinvertierten Version CKD bereitzustellen. Der Taktsignalinverter und der Taktsignalauffrischer 221 weist zwei in Serie geschaltete Inverter 223a, 223b auf, wobei das invertierte Taktsignal CKN an einem Ausgang eines ersten Inverters 223a der in Serie geschalteten Inverter 223a, 223b abgegriffen wird und das nichtinvertierte Taktsignal CKD an einem Ausgang eines zweiten Inverters 223b der zwei in Serie geschalteten Inverter 223a, 223b des Taktsignalinverters und Taktsignalauffrischers 221 abgegriffen wird. In dem Schieberegister 200 liegt das Taktsignal CK daher in einer invertierten Version CKN und einer nichtinvertierten Version CKD vor.

Der Dateneingang 103a des ersten Latches 201a bildet gleichzeitig den Dateneingang 115 des Schieberegisters 200. Das erste Latch 201a weist einen ersten Eingangsschalter 225a und eine erste Rückkopplungsschleife 227a auf. Der erste Eingangsschalter 225a ist zwischen die erste Rückkopplungsschleife 227a und den Dateneingang 103a des ersten Latches 201a geschaltet. Der erste Eingangsschalter 225a ist ausgelegt, um in dem transparenten Betriebszustand des ersten Latches 201a die erste Rückkopplungsschleife 227a mit dem Dateneingang 103a des ersten Latches 201a zu koppeln, derart, dass ein an dem Dateneingang 103a anliegender Signalzustand eines Datensignals D in die erste Rückkopplungsschleife 227a übernommen wird. Die erste Rückkopplungsschleife 227a ist ausgebildet, um im nichttransparenten Betriebszustand den in dem transparenten Betriebszustand des ersten Latches 201 a übernommenen Signalzustand aufrechtzuerhalten.

In der vorliegenden Anmeldung soll unter einem geschlossenen Zustand eines Schalters verstanden werden, dass der Schalter (bzw. eine Schaltstrecke des Schalters) leitend (oder niederohmig) ist. Unter einem offenen oder geöffneten Zustand eines Schalters soll verstanden werden, dass der Schalter (bzw. eine Schaltstrecke des Schalters) nicht leitend (oder hochohmig) ist.

Der erste Eingangsschalter 225a ist damit geschlossen; wenn das erste Latch 201a in dem transparenten Betriebszustand ist und ist geöffnet, wenn das erste Latch 201a in dem nichttransparenten Betriebszustand ist.

Analog zu dem ersten Latch 201a weist auch das zweite Latch 201b einen zweiten Eingangsschalter 225b und eine zweite Rückkopplungsschleife 227b auf. Auch bei dem zweiten Latch 201b ist der zweite Eingangsschalter 225b zwischen den Dateneingang 103b und die zweite Rückkopplungsschleife 227b geschaltet. Die beiden Eingangsschalter 225a, 225b der beiden Latches 201 a, 201 b sind komplementär zueinander angesteuert, d. h. in einem Zustand, in dem der erste Eingangsschalter 225a geöffnet ist, ist der zweite Eingangsschalter 225b geschlossen und in einem Zustand, in dem der erste Eingangsschälter 225a geschlossen ist, ist der zweite Eingangsschalter 225b geöffnet.

In dem in Fig. 2a gezeigten exemplarischen Beispiel weist die erste Rückkopplungsschleife 227a einen ersten Inverter 229a sowie einen dazu in Reihe geschalteten (beispielsweise direkt verbundenen) zweiten Inverter 231a und einen zu dem zweiten Inverter 231a in Reihe geschalteten ersten Rückkopplungsschalter 233a auf. Ein Eingang des ersten Inverters 229a der ersten Rückkopplungsschleife 227a bildet gleichzeitig einen Eingang der ersten Rückkopplungsschleife 227a und ist mit dem ersten Eingangsschalter 225a gekoppelt. Der Rückkopplungsschalter 233a der Rückkopplungsschleife 227a ist zwischen den Eingang des ersten Inverters 229a und einen Ausgang des zweiten Inverters 231 a der ersten Rückkopplungsschleife 227a geschaltet.

Analog zu der ersten Rückkopplungsschleife 227a weist auch die zweite Rückkopplungsschleife 227b zwei in Serie geschaltete (beispielsweise direkt miteinander verbundene) Inverter 229b, 231b und einen dazu in Serie geschalteten zweiten Rückkopplungsschalter 233b auf. Die Verschaltung der beiden Inverter 229b, 231b und des zweiten Rückkopplungsschalters 233b innerhalb des zweiten Latches 201b ist identisch der Verschaltung der Inverter 229a, 231a und des ersten Rückkopplungsschalter 233a in der ersten Rückkopplungsschleife 227a des ersten Latches 201 a.

Der erste Eingangsschalter 225a des ersten Latches 201a und der erste Rückkopplungsschalter 233a des ersten Latches 201a sind komplementär geschaltet, d. h. der erste Eingangsschalter 225a ist geöffnet, wenn der erste Rückkopplungsschalter 233a geschlossen ist und umgekehrt. Dasselbe gilt in entsprechender Weise für den zweiten Eingangsschalter 225b des zweiten Latches 201b und den zweiten Rückkopplungsschalter 233b des zweiten Latches 201b.

Die Rückkopplungsschalter 233a, 233b sind daher in dem transparenten Betriebszustand ihrer Latches 201a, 201b geöffnet und damit sind auch die Rückkopplungsschleifen 227a, 227b geöffnet. In dem nichttransparenten Betriebszustand ihrer Latches 201a, 201b sind die Rückkopplungsschalter 233a, 233b geschlossen, damit sind auch die Rückkopplungsschleifen 227a, 227b geschlossen und ein in das jeweilige Latch übernommener Signalwert wird in den Rückkopplungsschleifen 227a, 227b aufrechterhalten.

Weiterhin weist die erste Ausgangsschaltung 207a einen ersten Umschalter 235a mit einem ersten Eingang 237a und einem zweiten Eingang 239a auf. Der erste Umschalter 235a ist ausgelegt, um in einem ersten Schaltzustand seinen ersten Eingang 237a mit dem ersten Schieberegisterausgang 111a zu koppeln und in einem zweiten Schaltzustand seinen zweiten Eingang 239a mit dem ersten Schieberegisterausgang 111a zu koppeln. Der erste Eingang 237a des ersten Umschalters 235a ist mit dem Ausgang 109a des ersten Latches 201a gekoppelt (beispielsweise direkt verbunden). An dem zweiten Eingang 239a des ersten Umschalters 235a liegt der von dem in dem ersten Latch 201a vorliegenden Signalzustand unabhängige Pegel (beispielsweise Versorgungsspannungspegel) an. In dem in Fig. 2a gezeigten Ausführungsbeispiel wird der in der ersten Rückkopplungsschleife 227a gespeicherte Signalzustand an einem Ausgang des ersten Inverters 229a der Rückkopplungsschleife 227a abgegriffen (Knoten int1). Ein Aüsgangssignal an dem Ausgang 109a des ersten Latches 201a ist damit invertiert zu dem an dem ersten Latch 201a ursprünglich anliegenden Signalzustand. Um diese Invertierung auszugleichen und um eine Ausgangslast treiben zu können, kann die erste Ausgangsschaltung 207a weiterhin einen Inverter 241 a aufweisen, welcher zwischen einen Ausgang 244a des ersten Umschalters 235a und den ersten Schieberegisterausgang 111a geschaltet ist.

Weiterhin weist die zweite Ausgangsschaltung 207b einen zweiten Umschalter 235b mit einem ersten Eingang 237b und einem zweiten Eingang 239b auf. Der zweite Umschalter 235b ist analog zu dem ersten Umschalter 235a ausgebildet, um in seinem ersten Schaltzustand seinen ersten Eingang 237b mit dem zweiten Schieberegisterausgang 111b zu koppeln und in seinem zweiten Schaltzustand seinen zweiten Eingang 239b mit dem zweiten Schieberegisterausgang 111b zu koppeln. Der erste Eingang 237b ist dabei so geschaltet, dass ein Pegel an diesem Eingang abhängig von dem in der zweiten Rückkopplungsschleife 227b gespeicherten Signalzustand ist. Der zweite Eingang ist so geschaltet, dass an diesem der von dem in dem zweiten Latch 201b anliegenden Signalzustand unabhängige Pegel anliegt (beispielsweise Versorgungspotential und beispielsweise gleich dem Pegel an dem zweiten Eingang 239a des ersten Umschalters 235a).

Die Verschaltung des zweiten Umschalters 235b mit dem zweiten Latch 201b unterscheidet sich von der Verschaltung des ersten Umschalter 235a mit dem ersten Latch 201a dadurch, dass der erste Eingang 237b des zweiten Umschalters 235b mit einem Ausgang des zweiten Inverters 231b der zweiten Rückkopplungsschleife 227b gekoppelt ist. Ein an den ersten Eingang 237b des zweiten Umschalters 235b anliegender Pegel ist daher gleich einem Pegel des in der zweiten Rückkopplungsschleife 227b des zweiten Latches 201b gespeicherten Signalzustands.

An dem Ausgang des zweiten Inverters 231 b der zweiten Rückkopplungsschleife 227b liegt das ursprünglich an dem Dateneingang 115 des Schieberegisters 200 anliegende Datensignal D invertiert an (aufgrund der dreifachen Invertierung durch die Inverter 229a, 229b, 231b). Dieses Signal wird über einen Inverter 241b der zweiten Ausgangsschaltung 207b, welche zwischen einen Ausgang 244b, des zweiten Umschalters 235b und den zweiten Schieberegisterausgang 111b geschaltet ist, korrigiert. Weiterhin dient der Inverter 241b zum Treiben einer Ausgangslast.

Gemäß weiteren Ausführungsbeispielen können die Inverter 241 a, 241 b auch weggelassen werden, beispielsweise wenn der erste Eingang 237a des ersten Umschalters 235a mit dem Ausgang des zweiten Inverters 231 a der ersten Rückkopplungsschleife 227a gekoppelt ist und der erste Eingang 237b des zweiten Umschalters 235b mit einem Ausgang des ersten Inverters 229b der zweiten Rückkopplungsschleife 227b gekoppelt ist.

Takteingänge 117a, 117b der Umschalter 235a, 235b sind so geschaltet, dass der zweite Umschalter 235b in dem zweiten Schaltzustand ist (und seinen zweiten Eingang 239b mit dem zweiten Schieberegisterausgang 111b koppelt) wenn der erste Umschalter 235a in dem ersten Schaltzustand ist (und seinen ersten Eingang 237a mit dem ersten Schieberegisterausgang 111a koppelt) und umgekehrt. Dies ist in Fig. 2a daran erkennbar, dass der erste Umschalter 235a die nichtinvertierte Version CKD des Taktsignals CK erhält, während der zweite Umschalter 235b die invertierte Version CKN des Taktsignals CK erhält. Mit anderen Worten liegt an einem Takteingang 117a des ersten Umschalters 235a die nichtinvertierte Version CKD des Taktsignals CK und an einem Takteingang 117b des zweiten Umschalters 235b die invertierte Version CKN des Taktsignals CK an.

Dadurch, dass der Takteingang 113 des Schieberegisters 200 sowohl mit den Takteingängen der Latches 201 a, 201 b als auch mit den Takteingängen der Ausgangsschaltungen 207a, 207b gekoppelt ist, kann erreicht werden, dass ansprechend auf einen Taktzustandswechsel an dem Takteingang 113 des Schieberegisters 200 sowohl die Betriebszustände der Latches 201a, 201b als auch die Schaltzustände der Ausgangsschaltungen 207a, 207b wechseln. Mit anderen Worten, basieren die Betriebszustandswechsel der Latches 201a, 201b sowie die Schaltzustandswechsel der Ausgangsschaltungen 207a, 207b (bzw. deren Umschalter 235a, 235b) auf dem Taktsignal CK an dem Taktsignaleingang 113 des Schieberegisters 200. Das Schieberegister 200 kann daher einen einzigen Taktsignaleingang aufweisen und eine interne Taktverteilung aufweisen. Dadurch, dass sowohl die Ausgangsschaltungen 207a, 207b als auch die Latches 201a, 201b auf demselben Taktsignal CK basieren, kann erreicht werden, dass die Latches 201a, 201b mit den Ausgangsschaltungen 207a, 207b synchron schalten,

Gemäß einigen Ausführungsbeispielen können die Umschalter 235a, 235b taktzustandsgesteuert sein. So kann beispielsweise der erste Umschalter 235a in dem ersten Schaltzustand sein, wenn ein erster Pegel (beispielsweise ein "1"-Pegel) an seinem Takteingang anliegt und in dem zweiten Schaltzustand sein, wenn ein zu dem ersten Pegel komplementärer Pegel (beispielsweise ein "0"-Pegel) an seinem Takteingang anliegt. Dies gilt analog auch für den zweiten Umschalter 235b. Wobei allerdings zu beachten ist, dass aufgrund der invertierten Beschaltung der beiden Umschalter 235a, 235b (sichtbar daran, dass der erste Umschalter 235a die nichtinvertierte Version CKD des Taktsignals CK bekommt und der zweite Umschalter 235b die invertierte Version CKN des Taktsignal CK bekommt) auch die Schaltzustände der beiden Umschalter 235a, 235b komplementär zueinander sind. Realisierungstechnisch können die beiden Umschalter 235a, 235b identisch ausgeführt sein, d. h. dass ein Pegel der zu dem ersten Schaltzustand des ersten Umschalters 235a führt auch bei dem zweiten Umschalter 235b zu dem ersten Schaltzustand führt und dass ein Pegel, der bei dem ersten Umschalter 235a zu dem zweiten Schaltzustand führt auch bei dem zweiten Umschalter 235b zu dem zweiten Schaltzustand führt.

Weiterhin weist das Schieberegister 200 einen dritten Schieberegisterausgang 241 auf. Der dritte Schieberegisterausgang 241 dient dazu, um eine D-Flip-Flop-Funktionalität des in Fig. 2a gezeigten Schieberegisters 200 zu realisieren. An dem dritten Schieberegisterausgang 241 liegt daher das an dem Schieberegistereingang 115 anliegende Datensignal mit einer Verzögerung von einer Taktperiode des Taktsignals CK an. Der dritte Schieberegisterausgang 241 kann benutzt werden, um mehrere der Schieberegister 200 miteinander zu koppeln, um ein Einer-Aus-Vielen-Schieberegister zu realisieren. So kann der dritte Schieberegisterausgang 241 eines ersten Schieberegisters 200 bei einem Einer-Aus-Vielen-Schieberegister mit einem Dateneingang 115 eines folgenden Schieberegisters 200 gekoppelt (beispielsweise direkt verbunden) sein. In dem in Fig. 2a gezeigten Ausführungsbeispiel ist der dritte Schieberegisterausgang 241 mit dem Ausgang des ersten Inverters 229b der zweiten Rückkopplungsschleife 227b des zweiten Latches 201 b gekoppelt. Das zweite Latch 201b weist daher zwei Ausgänge auf, wobei an dem einen Ausgang der von dem Dateneingang 103b des zweiten Latches 201b übernommene Signalzustand in invertierter Form anliegt (an dem dritten Schieberegisterausgang 241) und an dem anderen Ausgang (welcher mit dem Eingang 237b des zweiten Umschalters 235b gekoppelt ist) in nichtinvertierter Form anliegt.

Mit anderen Worten, ist das zweite Latch 201b so mit dem dritten Schieberegisterausgang 241 gekoppelt (beispielsweise direkt verbunden), dass ein Pegel an dem dritten Schieberegisterausgang 241 einem an dem Dateneingang 103a des ersten Latches 201a nach einer vorgegebenen Anzahl von Taktsignalflanken (beispielsweise zwei) des Taktsignals CK an dem Taktsignaleingang 113 des Schieberegisters 200 folgt.

Der Pegel an dem dritten Schieberegisterausgang 241 basiert daher lediglich auf dem in der Rückkopplungsschleife 227b des zweiten Latches 201b herrschenden Signalzustands und ist unabhängig von den Schaltzuständen der Ausgangsschaltungen 207a, 207b.

In dem in Fig. 2a gezeigten Ausführungsbeispiel sind die Eingangsschalter 225a, 225b und die Rückköpplungsschalter 233a, 233b durch parallel geschaltete Transistoren, beispielsweise in Form von Transmission Gates (Übertragungsgattern) 225a, 225b, 233a, 233b realisiert. Transmission Gates eines Latches (beispielsweise das Transmission Gate 225a und das Transmission Gate 233a des ersten Latches 201a) sind dabei invertiert angesteuert.

Gemäß weiteren Ausfilhrungsbeispielen können die Eingangsschalter 225a, 225b und die Rückkopplungsschalter 233a, 233b auch mit anderen Schaltern, wie beispielsweise Relais oder Ein-Transistorschaltern realisiert werden.

Weiterhin ist der erste Umschalter 235a der ersten Ausgangsschaltung 207a durch einen ersten Schalttransistor 243a und einen zweiten Schalttransistor 245a realisiert. Der erste Schalttransistor 243a ist ein n-Kanal-Feldeffekttransistor und der zweite Schalttransistor 245a ist ein p-Kanal-Feldeffekttransistor. Eine Source-Drain-Strecke des ersten Schalttransistors 243a des ersten Umschalters 235a ist zwischen den ersten Eingang 237a und den Ausgang 244a des ersten Umschalters 235a geschaltet. Eine Source-Drain-Strecke des zweiten Schalttransistors 245a des ersten Umschalters 235a ist zwischen den zweiten Eingang 239a und den Ausgang 244a des ersten Umschalters 235a geschaltet. An Gateanschlüssen der beiden Schalttransistoren 243a, 245a des ersten Umschalters 235a liegt das Taktsignal CK in der nichtinvertierten Version CKD an.

Auch der zweite Umschalter 235b ist mit einem ersten Schalttransistor 243b, welcher ein n-Kanal-Feldeffekttransistor ist und einen zweiten Schalttransistor 245b, welcher ein p-Kanal-Feldeffekttransistor ist, realisiert. Eine Source-Drain-Strecke des ersten Schalttransistors 243b ist zwischen den ersten Eingang 237b und den Ausgang 244b des zweiten Umschalters 235b geschaltet. Eine Source-Drain-Strecke des zweiten Schalttransistors 245b des zweiten Umschalters 235b ist zwischen den zweiten Eingang 239b und den Ausgang 244b des zweiten Umschalters 235b geschaltet. An Gateeingängen der beiden Schalttransistoren 243b, 245b des zweiten Umschalters 235b liegt das Taktsignal CK in der invertierten Version CKN an, so kann gewährleistet werden, dass der erste Umschalter 235a invertiert zu dem zweiten Umschalter 235b schaltet.

Gemäß weiteren Ausführungsbeispielen können die Schalttransistoren 243a, 245a, 243b, 245b auch durch Übertragungsgatter (Transmission Gates), vergleichbar den Schaltern 225a, 225b, 233a, 233b, ersetzt werden.

Obwohl in dem in Fig. 2a gezeigten Ausführungsbeispiel die Eingangsschalter 225a, 225b, die Rückkopplungsschalter 233a, 233b sowie die Transistoren 243a, 243b, 245a, 245b als Feldeffekttransistoren ausgebildet sind, so können bei weiteren Ausführungsbeispielen auch andere Transistortypen, wie beispielsweise Bipolartransistoren, verwendet werden. Weiterhin ist auch eine komplementäre Realisierung zu der in Fig. 2a gezeigten Realisierung möglich, beispielsweise unter Nutzung einer invertierten Taktansteuerung.

Im Folgenden soll die Funktionalität des in Fig. 2a gezeigten Schieberegisters 200 anhand eines in Fig. 2b gezeigten Zeitzustandsdiagramms erläutert werden. In dem in Fig. 2b gezeigten Zeitzustandsdiagramm sind die folgenden Signale über die Zeit abgetragen:
die nichtinvertierte Version CKD des Taktsignals CK;
die invertierte Version CKN des Taktsignals CK;
der Pegel des Datensignals D an dem Dateneingang 115 des Schieberegisters 200 und damit an den Dateneingang 103a des ersten Latches 201a;
der Pegel an dem Ausgang 109a des ersten Latches 201a (Knoten int1);
der Pegel an dem Ausgang 109b des zweiten Latches 201b (Knoten int2);
der Pegel an dem ersten Schieberegisterausgang 111a (O0);
der Pegel an dem zweiten Schieberegisterausgang 111b (O1);
der Pegel an dem dritten Schieberegisterausgang 241 (Q);
der Pegel an dem Knoten zwischen dem ersten Eingangsschalter 233a und dem ersten Inverter 229a der ersten Rückkopplungsschleife 227a des ersten Latches 201b (Knoten int3);
der Pegel an dem Ausgang 244a des ersten Umschalters 235a (Knoten int4);
der Pegel an dem Knoten zwischen dem zweiten Rückkopplungsschalter 233b und dem ersten Inverter 229a der Rückkopplungsschleife 227b des zweiten Latches 201 b (Knoten int5); und
der Pegel an dem Ausgang 244b des zweiten Umschalters 235b der zweiten Rückkopplungsschaltung 207b (Knoten int6).

In dem in Fig. 2b gezeigten Diagramm sieht man, dass die internen Knoten int1 und int2 überlappende Werte haben (wegen eines fehlenden Eingangsinverters an dem Schieberegister 200 sind diese Signale gegenüber dem Datensignal D invertiert). Die NMOS-Schalter (die Schalttransistoren 243a, 243b) und die PMOS-Schalter (die Schalttransistoren 245a, 245b) korrigieren diese Überlappung, so dass während CKD "1"-Pegel hat, O0 einen "1"-Pegel ausgibt, während bei einem "0"-Pegel von CKD O1 einen "1"-Pegel ausgibt.

O0 gibt einen "1"-Pegel aus, wenn der Knoten int1 einen "0"-pegel hat und CKD einen "1"-Pegel hat. Dann ist der NMOS-Schalter 243a an dem Knoten int1 geschlossen und leitet den Wert weiter an den Ausgangsinverter 241 a.

Das funktioniert sehr gut, falls der Knoten "0"-Pegel hat, wenn also eine "1" in dem Latch 201a gespeichert ist. Hat der Knoten int1 "1"-Pegel, so leitet der NMOS-Schalter 243a nicht bis zum vollen "1"-Pegel. Der Pegel am Invertereingang des Inverters 241 a ist aber so hoch, dass der Inverterausgang (der erste Schieberegisterausgang 111a) richtig auf "0"-Pegel gesetzt wird. Der PMOS-Schalter 245a setzt den Invertereingang des Ausgangsinverters 241 a immer bei einem "0"-Pegel von CKD auf einen vorgegebenen Pegel (in dem in Fig. 2a gezeigten Ausführungsbeispiel auf "1"-Pegel). Die Schalter an dem Knoten int2 sind invertiert dazu angesteuert, so dass die "1" während eines "0"-Pegels von CKD am zweiten Schieberegisterausgang 111b erscheint.

Aus dem in Fig. 2b gezeigten Diagramm wird deutlich, dass das Schieberegister 200 einen "1"-Pegel an seinem Dateneingang 115 bei jeder Taktflanke des Taktsignals CK weiter schiebt und nicht, wie dies bei einem konventionellen D-Flip-Flop der Fall ist, bei jeder zweiten Taktflanke. Des Weiteren liegt an den beiden Schieberegisterausgängen 111a, 111b der von dem Dateneingang 115 übernommene "1"-Pegel immer nur für eine halbe Taktperiode des Taktsignals CK an. Des Weiteren wird aber auch von dem Schieberegister 200 die typische taktzustandsgesteuerte D-Flip-Flop-Funktionalität an dem dritten Schieberegisterausgang 241 bereitgestellt. Dieser bereitgestellte Pegel kann in einem nachfolgenden Schieberegister als Eingang benutzt werden.

Das in Fig. 2a gezeigte Schieberegister (oder Flip-Flop 200) weist für die zwei Schieberegisterausgänge 111a, 111b lediglich 28 Transistoren auf, d. h. pro Schieberegisterausgang 14. Das heißt für ein Einer-Aus-Vielen-Schieberegister, wie es beispielsweise in Abbildung 3 zusammengeschaltet wird, werden N * 14 Transistoren benötigt (N ist die Anzahl der Latches bzw. die Anzahl der durch die Ausgangsschaltungen gesteuerten Schieberegister-ausgänge).

Fig. 3 zeigt ein Blockschaltbild eines Einer-Aus-Vielen-Schieberegisters 300 gemäß einem weiteren Ausführungsbeispiel. Das Einer-Aus-Vielen-Schieberegister 300 weist einen Dateneingang 301 und einen Takteingang 303 auf. Das Einer-Aus-Vielen-Schieberegister 300 weist eine Mehrzahl von in Serie geschalteten Schieberegistern 200a bis 200n auf. Die Schieberegister 200a bis 200n können, beispielsweise, wie das in Fig. 2a gezeigte Schieberegister 200 aufgebaut sein.

Die Schieberegister 200a bis 200n sind so mit dem Dateneingang 301 und dem Takteingang 303 gekoppelt, dass eine an dem Dateneingang 301 anliegende "1" durch die Schieberegister 200a bis 200n hindurch geschoben, derart, dass bei einer fallenden (oder steigenden) Taktflanke an dem Takteingang 303 die "1" von einem ersten Schieberegisterausgang eines Schieberegisters zu einem zweiten Schieberegisterausgang desselben Schieberegisters weiter geschoben wird und dass bei einer steigenden (oder fallenden) Taktflanke die "1" von dem zweiten Schieberegisterausgang des Schieberegisters zu einem ersten Schieberegisterausgang eines folgenden Schieberegisters weiter geschoben wird. Mit anderen Worten wird bei einer ersten Taktflankenrichtung die "1" intern in den Schieberegistern weiter geschoben, während bei einer zweiten Taktflankenrichtung (welche komplementär zu der ersten Taktflankenrichtung ist) die "1" von einem Schieberegister in das nächste Schieberegister weiter geschoben wird. So wird beispielsweise unter Nutzung der Implementierung der Schieberegister, wie in Fig. 2a gezeigt, eine "1" an dem Dateneingang 301 des Einer-Aus-Vielen-Schieberegisters 300, welche in einem ersten Schieberegister 200a der Mehrzahl von Schieberegistern 200a bis 200n gespeichert ist, bei einer fallenden Taktflanke von dem ersten Schieberegisterausgang O0 des ersten Schieberegisters 200a zu dem zweiten Schieberegisterausgang O1 des ersten Schieberegisters 200a weiter geschoben und bei einer darauf folgenden steigenden Taktflanke von dem ersten Schieberegister 200a in ein zweites Schieberegister 200b (welches dem ersten Schieberegister 200a nachgeschaltet ist) weiter geschoben, so dass die "1" dann an dem ersten Schieberegisterausgang 02 des zweiten Schieberegisters 200b anliegt.

Die Schieberegister 200a bis 200n können direkt miteinander verbunden sein, d. h. ein dritter Schieberegisterausgang des ersten Schieberegisters 200a kann mit einem Dateneingang des zweiten Schieberegisters 200b direkt verbunden sein (beispielsweise ohne zusätzliche Verstärker oder Inverter oder Schalter). Dies gilt ebenso für die Serienschaltungen der weiteren Schieberegister 200c bis 200n.

Durch die direkte Verschaltung der Schieberegister 200a bis 200n miteinander kann sowohl der in Fig. 5 gezeigte Eingangsinverter 501 als auch der Ausgangsinverter 505 bei den Schieberegistern 200a bis 200n weg gelassen werden, da die Flip-Flops bzw. Schieberegister 200a bis 200n direkt aneinander angeschlossen sind (ohne Logik und lange Leitungen) und dadurch eine Signalauffrischung nicht notwendig ist. Durch diese Eliminierung des Eingangsinverters und des Ausgangsinverters bei den Schieberegistern 200a bis 200n lässt sich zusätzlich die Anzahl der Transistoren, die für die Implementierung des Einer-Aus-Vielen-Schieberegisters 300 benötigt werden reduzieren. Eine weitere Reduzierung der benötigten Transistoren wird, wie im Vorhergehenden bereits erläutert, dadurch erreicht, dass beide Latchausgänge für die Schieberegisterausgänge benutzt werden.

Das in Fig. 3 gezeigte Einer-Aus-Vielen-Schieberegister kommt daher mit N * 14 Transistoren aus, (wobei N die Anzahl der Ausgänge des Schieberegisters 300 oder das Doppelte der Anzahl der Schieberegister 200a bis 200n ist).

Durch die reduzierte Anzahl an Transistoren wird der Flächenbedarf für das gesamte Einer-Aus-Vielen-Schieberegister 300 und für jedes einzelne Schieberegister 200a bis 200n deutlich geringer.

Ausführungsbeispiele der vorliegenden Erfindung funktionieren für (nahezu) alle Taktfrequenzen; auch für sehr niedrige, oder wenn man den Takt für einige Zeit anhält.

Zusätzlich wird der Ausgang bei jeder Taktflanke weiter geschoben, so dass die Taktfrequenz halbiert werden kann, was Störungen anderer Schaltungsteile auf demselben integrierten Schaltkreis reduziert.

Gemäß weiteren Ausführungsbeispielen können für leichte Ausgangslasten auch die in Fig. 2a gezeigten Ausgangsinverter 241a, 241b weggelassen werden, wodurch sich eine weitere Reduzierung der Anzahl der benötigten Transistoren ergibt.

Weiterhin kann gemäß Ausführungsbeispielen an beliebiger Stelle ein Inverter durch eine Kaskadierung von Invertern ersetzt werden. Die Kaskadierung der Inverter könnte auch über die Schalter hinweg erfolgen.

Gemäß weiteren Ausführungsbeispielen kann das in Fig. 2a gezeigte Schieberegister 200 auch zusätzlich einen Eingangsinverter an dem Dateneingang 115 und einen Ausgangsinverter an dem dritten Schieberegisterausgang 241 aufweisen.

Gemäß weiteren Ausführungsbeispielen kann auch für die Invertierung der Signale ein Abgriff der Ausgangsschaltereingänge (der Ausgangsschaltungen) vor dem jeweiligen Inverter, oder nach dem jeweiligen nächsten Inverter der Rückkopplungskette (der Rückkopplungsschleifen 227a, 227b) möglich sein.

Gemäß weiteren Ausführungsbeispielen können durch. Einfügen zusätzlicher Inverter einige Zwischensignale invertiert werden. Dadurch kann sich beispielsweise die Polarität der Ein-Transistorschalter 243a, 245a, 243b, 245b umkehren (statt NMOS → PMOS und umgekehrt) sowie die Ansteuerpegel (statt CKN → CKD und umgekehrt).

Gemäß weiteren Ausführungsbeispielen kann der dritte Schieberegisterausgang 241 sich durch zusätzliche Inverter im Pfad verschieben, beispielsweise vor dem vorherigen oder dem nächsten Inverter.

Ausführungsbeispiele können ihre Anwendung beispielsweise in Bildsensoren, oder allgemein in Multiplexern finden.

Ausführungsbeispiele schaffen damit ein flächeneffizienteres D-Flip-Flop für ein Einer-Aus-Vielen-Schieberegister.

Bei konventionellen Schieberegistern wird für jeden Ausgang ein D-Flip-Flop benötigt. Da herkömmliche D-Flip-Flop-Implementierungen (wie beispielsweise in Fig. 5 gezeigt) 24 Transistoren besitzen, werden auch pro Schieberegisterausgang 24 Transistoren benötigt. Ausführungsbeispiele ermögliche eine Reduktion der der benötigten Transistoren pro Schieberegisterausgang (beispielsweise auf 14 Transistoren pro Schiebregisterausgang, wie in Fig. 2a gezeigt).

Ein Ausführungsbeispiel der Erfindung schafft eine Einer-Aus-Vielen-Auswahlschaltung mit einem Einer-Aus-Vielen-Schieberegister 300 mit einem Dateneingang 301 und einem Takteingang 303, wobei das Einer-Aus-Vielen-Schieberegister 300 die folgenden Merkmale aufweist: eine Mehrzahl von in Serie geschalteten Schieberegistern 100; 200; 200a - 200n mit folgenden Merkmalen: einem ersten Latch 101a; 201a, das ausgelegt ist, um in einem transparenten Betriebszustand einen an seinem Dateneingang 103a anliegenden Signalzustand zu übernehmen und um in einem nichttransparenten Betriebszustand den übernommenen Signalzustand aufrechtzuerhalten; einem zweiten Latch 101b; 201b, das ausgelegt ist, um in einem transparenten Betriebszustand einen an seinem Dateneingang 103b anliegenden Signalzustand zu übernehmen und um in einem nichttransparenten Betriebszustand den übernommenen Signalzustand aufrechtzuerhalten; wobei das erste Latch 101a; 201a und das zweite Latch 101b; 201b in Serie geschaltet sind; wobei Takteingänge 105a, 105b der Latches 101a, 101b; 201a, 201b so geschaltet sind, dass das zweite Latch 101b; 201b in dem transparenten Betriebszustand ist, wenn das erste Latch 101a; 201a in dem nichttransparenten Betriebszustand ist und umgekehrt; einer ersten Ausgangsschaltung 107a, 207a, die ausgelegt ist, um an einem ersten Schieberegisterausgang 111a des Schieberegisters 100, 200; 200a - 200n in dem transparenten Betriebszustand des ersten Latches 101a; 201a einen vorgegebenen, von dem in dem ersten Latch 101a; 201a vorhandenen Signalzustand unabhängigen Pegel bereitzustellen, und in dem nichttransparenten Betriebszustand des ersten Latches 101a; 201a einen von dem in dem ersten Latch 101a; 201a gespeicherten Signalzustand abhängigen Pegel bereitzustellen; und einer zweiten Ausgangsschaltung 107b, 207b, die ausgelegt ist, um an einem zweiten Schieberegisterausgang 111b des Schieberegisters 100, 200, 200a - 200n in dem transparenten Betriebszustand des zweiten Latches 101b, 201b einen vorgegebenen, von dem in dem zweiten Latch 101b, 201b vorhandenen Signalzustand unabhängigen Pegel bereitzustellen, und in dem nichttransparenten Betriebszustand des zweiten Latches 101b, 201b einen von dem in dem zweiten Latch 101b, 201b gespeicherten Signalzustand abhängigen Pegel bereitzustellen; wobei die Schieberegister 200a - 200n so mit dem Dateneingang 301 und dem Takteingang 303 gekoppelt sind, dass eine an dem Dateneingang 301 anliegende "1" durch die Schieberegister 200a - 200n hindurch geschoben wird, derart, dass bei einer fallenden Taktflanke an dem Takteingang 303 die "1" von einem ersten Schieberegisterausgang O0 eines ersten Schieberegisters 200a der Mehrzahl von Schieberegistern 200a - 200n zu einem zweiten Schieberegisterausgang O1 desselben Schieberegisters 200a weiter geschoben wird und dass bei einer steigenden Taktflanke die "1" von dem zweiten Schieberegisterausgang O1 des ersten Schieberegisters 200a zu einem ersten Schieberegisterausgang 02 eines folgenden Schieberegisters 200b weiter geschoben wird; oder dass bei einer steigenden Taktflanke an dem Takteingang 303 die "1" von einem ersten Schieberegisterausgang O0 eines ersten Schieberegisters 200a der Mehrzahl von Schieberegistern 200a - 200n zu einem zweiten Schieberegisterausgang O1 desselben Schieberegisters 200a weiter geschoben wird und dass bei einer fallenden Taktflanke die "1" von dem zweiten Schieberegisterausgang O1 des ersten Schieberegisters 200a zu einem ersten Schieberegisterausgang 02 eines folgenden Schieberegisters 200b weiter geschoben wird.

Bei einem Ausführungsbeispiel der Einer-Aus-Vielen-Auswahlschaltung weist das erste Latch 201a einen ersten Eingangsschalter 225a und einen dazu komplementär geschalteten ersten Rückkopplungsschalter 233a auf; wobei der erste Eingangsschalter 225a in dem transparenten Betriebszustand des ersten Latches 201a leitend ist, um den an dem Dateneingang 103a des ersten Latches 201a anliegenden Signalzustand zu übernehmen, und in dem nichttransparenten Betriebszustand nicht leitend ist; wobei der erste Rückkopplungsschalter 233a in dem nichttransparenten Betriebszustand des ersten Latches 201a leitend ist, um den von dem Dateneingang 103a des ersten Latches 201a übernommenen Signalzustand in dem ersten Latch 201a aufrechtzuerhalten; das zweite Latch 201b weist einen zweiten Eingangsschalter 225b und einen dazu komplementär geschalteten zweiten Rückkopplungsschalter 233b auf; wobei der erste Eingangsschalter 225b in dem transparenten Betriebszustand des zweiten Latches 201b leitend ist, um den an dem Dateneingang 103b des zweiten Latches 201b anliegenden Signalzustand zu übernehmen, und in dem nichttransparenten Betriebszustand des zweiten Latches 201b nicht leitend ist; wobei der zweite Rückkopplungsschalter 233b in dem nichttransparenten Betriebszustand des zweiten Latches 201b leitend ist, um den von dem Dateneingang 103b des zweiten Latches 201b übernommenen Signalzustand in dem zweiten Latch 201b aufrechtzuerhalten.

Bei einem weiteren Ausführungsbeispiel der Einer-Aus-Vielen-Auswahlschaltung weist das erste Latch 201a eine erste Rückkopplungsschleife 227a auf; wobei die erste Rückkopplungsschleife 227a hinter dem ersten Eingangsschalter 225a geschaltet ist und der erste Rückkopplungsschalter 233a ausgelegt ist, um die erste Rückkopplungsschleife 227a zu öffnen und zu schließen, um in dem transparenten Betriebszustand des ersten Latches 201a bei geöffneter erster Rückkopplungsschleife 227a den an dem Dateneingang 103a des ersten Latches 201a anliegenden Signalzustand in die erste Rückkopplungsschleife 227a zu übernehmen und um in dem nichttransparenten Betriebszustand des ersten Latches 201a bei geschlossener erster Rückkopplungsschleife 227a den übernommenen Signalzustand in der ersten Rückkopplungsschleife 227a aufrechtzuerhalten; das zweite Latch weist eine zweite Rückkopplungsschleife 227b auf; wobei die zweite Rückkopplungsschleife 227b hinter dem zweiten Eingangsschalter 225b geschaltet ist und der zweite Rückkopplungsschalter 233b ausgelegt ist, um die zweite Rückkopplungsschleife 227b zu öffnen und zu schließen, um in dem transparenten Betriebszustand des zweiten Latches 201b bei geöffneter zweiter Rückkopplungsschleifer 227a den an dem Dateneingang 103b des zweiten Latches 201b anliegenden Signalzustand in die zweite Rückkopplungsschleife 227b zu übernehmen und um in dem nichttransparenten Betriebszustand des zweiten Latches 201b bei geschlossener zweiter Rückkopplungsschleife 227b den übernommenen Signalzustand in der zweiten Rückkopplungsschleife 227b aufrechtzuerhalten.

Bei einem weiteren Ausführungsbeispiel der Einer-Aus-Vielen-Auswahlschaltung weist die erste Rückkopplungsschleife 227a zumindest zwei in Serie geschaltete Inverter 229a, 231a auf; wobei der erste Eingangsschalter 225a mit einem Eingang eines ersten Inverters 229a der zumindest zwei in Serie geschalteten Inverter 229a, 231a der ersten Rückkopplungsschleife 227a gekoppelt ist; wobei der erste Rückkopplungsschalter 233a zwischen einen Ausgang eines letzten Inverters 231a der zumindest zwei in Serie geschalteten Inverter 229a, 231a der ersten Rückkopplungsschleife 227a und den Eingang des ersten Inverters 229a der ersten Rückkopplungsschleife 227a geschaltet ist; die zweite Rückkopplungsschleife 227b des zweiten Latches 201b weist zumindest zwei in Serie geschaltete Inverter 229b, 231b auf; wobei der zweite Eingangsschalter 225b mit einem Eingang eines ersten Inverters 229b der zumindest zwei in Serie geschalteten Inverter 229b, 231b der zweiten Rückkopplungsschleife 227b gekoppelt ist; und wobei der zweite Rückkopplungsschalter 233b zwischen einen Ausgang eines letzten Inverters 231b der zumindest Serie geschalteten Inverter 229b, 231b der zweiten Rückkopplungsschleife 227b und den Eingang des ersten Inverters 229b der zweiten Rückkopplungsschleife 227b geschaltet ist.

Bei einem weiteren Ausführungsbeispiel der Einer-Aus-Vielen-Auswahlschaltung ist die zweite Ausgangsschaltung 207b mit dem Ausgang des zweiten Inverters 231b der zweiten Rückkopplungsschleife 227b gekoppelt, um in dem nichttransparenten Betriebszustand des zweiten Latches 201b den an dem zweiten Schieberegisterausgang 111b bereitgestellten Pegel in Abhängigkeit von einem Pegel an dem Ausgang des zweiten Inverters 231b der zweiten Rückkopplungsschleife 227b bereitzustellen.

Bei einem weiteren Ausführungsbeispiel der Einer-Aus-Vielen-Auswahlschaltung ist ein dritter Schieberegisterausgang 241 mit einem Ausgang des ersten Inverters 229b der zweiten Rückkopplungsschleife 227b gekoppelt, derart, dass ein Pegel an dem dritten Schieberegisterausgang 241 auf einem Pegel an dem Ausgang des ersten Inverters 229b der zweiten Rückkopplungsschleife 227b basiert, und unabhängig von Schaltzuständen der beiden Ausgangsschaltungen 207a, 207b ist.

Bei einem weiteren Ausführungsbeispiel der Einer-Aus-Vielen-Auswahlschaltung ist das erste Latch 201a direkt verbunden mit dem zweiten Latch 201b, derart, dass ein an einem Ausgang 109a des ersten Latches 201a anliegender Pegel gleich einem an einem Dateneingang 103b des zweiten Latches 201b anliegenden Pegel ist.

Bei einem weiteren Ausführungsbeispiel der Einer-Aus-Vielen-Auswahlschaltung ist ein erster Eingang 237a der ersten Ausgangsschaltung 207a direkt verbunden mit einem Ausgang 109a des ersten Latches 201a; und ein erster Eingang 237b der zweiten Ausgangsschaltung 207b ist direkt verbunden mit einem Ausgang 109b des zweiten Latches 201b.

## Patentansprüche

1. Einer-Aus-Vielen-Auswahlschaltung mit einem Einer-Aus-Vielen-Schieberegister (300) mit einem Dateneingang (301) und einem Takteingang (303), wobei das Einer-Aus-Vielen-Schieberegister (300) die folgenden Merkmale aufweist:
eine Mehrzahl von in Serie geschalteten Schieberegistern (100; 200; 200a 200n) mit folgenden Merkmalen:
einem ersten Latch (101a; 201 a), das ausgelegt ist, um in einem transparenten Betriebszustand einen an seinem Dateneingang (103a) anliegenden Signalzustand zu übernehmen und um in einem nichttransparenten Betriebszustand den übernommenen Signalzustand aufrechtzuerhalten;
einem zweiten Latch (101b; 201b), das ausgelegt ist, um in einem transparenten Betriebszustand einen an seinem Dateneingang (103b) anliegenden Signalzustand zu übernehmen und um in einem nichttransparenten Betriebszustand den übernommenen Signalzustand aufrechtzuerhalten;
wobei das erste Latch (101a; 201a) und das zweite Latch (101b; 201b) in Serie geschaltet sind;
wobei Takteingänge (105a, 105b) der Latches (101a, 101b; 201a, 201b) so geschaltet sind, dass das zweite Latch (101b; 201b) in dem transparenten Betriebszustand ist, wenn das erste Latch (101a; 201a) in dem nichttransparenten Betriebszustand ist und umgekehrt;
einer ersten Ausgangsschaltung (107a, 207a), die ausgelegt ist, um an einem ersten Schieberegisterausgang (111a) des Schieberegisters (100, 200; 200a - 200n) in dem transparenten Betriebszustand des ersten Latches (101a; 201a) einen vorgegebenen, von dem in dem ersten Latch (101a; 201a) vorhandenen Signalzustand unabhängigen Pegel bereitzustellen, und in dem nichttransparenten Betriebszustand des ersten Latches (101a; 201 a) einen von dem in dem ersten Latch (101a; 201 a) gespeicherten Signalzustand abhängigen Pegel bereitzustellen; und
einer zweiten Ausgangsschaltung (107b, 207b), die ausgelegt ist, um an einem zweiten Schieberegisterausgang (111b) des Schieberegisters (100, 200, 200a - 200n) in dem transparenten Betriebszustand des zweiten Latches (101b, 201b) einen vorgegebenen, von dem in dem zweiten Latch (101b, 201 b) vorhandenen Signalzustand unabhängigen Pegel bereitzustellen, und in dem nichttransparenten Betriebszustand des zweiten Latches (101b, 201b) einen von dem in dem zweiten Latch (101b, 201b) gespeicherten Signalzustand abhängigen Pegel bereitzustellen;
wobei die Schieberegister (200a - 200n) so mit dem Dateneingang (301) und dem Takteingang (303) gekoppelt sind, dass eine an dem Dateneingang (301) anliegende "1" durch die Schieberegister (200a - 200n) hindurch geschoben wird, derart, dass bei einer fallenden Taktflanke an dem Takteingang (303) die "1" von einem ersten Schieberegisterausgang (O0) eines ersten Schieberegisters (200a) der Mehrzahl von Schieberegistern (200a - 200n) zu einem zweiten Schieberegisterausgang (O1) desselben Schieberegisters (200a) weiter geschoben wird und dass bei einer steigenden Taktflanke die "1" von dem zweiten Schieberegisterausgang (O1) des ersten Schieberegisters (200a) zu einem ersten Schieberegisterausgang (02) eines folgenden Schieberegisters (200b) weiter geschoben wird;
oder dass bei einer steigenden Taktflanke an dem Takteingang (303) die "1" von einem ersten Schieberegisterausgang (O0) eines ersten Schieberegisters (200a) der Mehrzahl von Schieberegistern (200a - 200n) zu einem zweiten Schieberegisterausgang (O1) desselben Schieberegisters (200a) weiter geschoben wird und dass bei einer fallenden Taktflanke die "1" von dem zweiten Schieberegisterausgang (O1) des ersten Schieberegisters (200a) zu einem ersten Schieberegisterausgang (02) eines folgenden Schieberegisters (200b) weiter geschoben wird.

2. Einer-Aus-Vielen-Auswahlschaltung gemäß Anspruch 1,
wobei die Takteingänge (105a, 105b) der beiden Latches (101a, 101b, 201a, 201b) invertiert geschaltet sind, derart, dass wenn an dem Takteingang (105a) des ersten Latches (101a, 201a) ein erster Pegel anliegt, an dem Takteingang (105b) des zweiten Latches (101b, 201b) ein zu dem ersten Pegel komplementärer Pegel anliegt.

3. Einer-Aus-Vielen-Auswahlschaltung gemäß einem der Ansprüche 1 oder 2,
wobei Takteingänge (117a, 117b) der Ausgangsschaltungen (107a, 107b, 207a, 207b) invertiert geschaltet sind, derart, dass wenn an einem Takteingang (117a) der ersten Ausgangsschaltung (107a, 207a) ein erster Pegel anliegt, ein zu dem ersten Pegel komplementärer Pegel an einem Takteingang (117b) der zweiten Ausgangsschaltung (107b, 207b) anliegt.

4. Einer-Aus-Vielen-Auswahlschaltung gemäß einem der Ansprüche 1 bis 3,
wobei ein Takteingang (113) der Schieberegister (100, 200) mit den Takteingängen (105a, 105b) der Latches (101a, 101b, 201a, 201b) und mit Takteingängen (117a, 117b) der Ausgangsschaltungen (107a, 107b, 207a, 207b) gekoppelt ist, derart, dass
ansprechend auf einen Taktzustandswechsel an dem Takteingang (113) der Schieberegister (100, 200) sowohl die Betriebszustände der Latches (101a, 101b, 201a, 201b) als auch Schaltzustände der Ausgangsschaltungen (107a, 107b, 207a, 207b) wechseln.

5. Einer-Aus-Vielen-Auswahlschaltung gemäß einem der Ansprüche 1 bis 4,
wobei die erste Ausgangsschaltung (207a) einen ersten Umschalter (235a) mit einem ersten Eingang (237a) und einem zweiten Eingang (239a) aufweist;
wobei der erste Umschalter (235a) ausgelegt ist, um in seinem ersten Schaltzustand seinen ersten Eingang (237a) mit dem ersten Schieberegisterausgang (111a) zu koppeln und um in seinem zweiten Schaltzustand seinen zweiten Eingang (239a) mit dem ersten Schieberegisterausgang (111 a) zu koppeln;
wobei der erste Umschalter (235a) so geschaltet ist, dass ein an seinem ersten Eingang (237a) anliegender Pegel auf dem in dem ersten Latch (201a) vorhandenen Signalzustand basiert, und dass ein an seinem zweiten Eingang (239a) anliegender Pegel unabhängig von dem in dem ersten Latch (201a) vorhandenen Signalzustand ist;
wobei die zweite Ausgangsschaltung (207b) einen zweiten Umschalter (235b) mit einem ersten Eingang (237b) und einem zweiten Eingang (239b) aufweist;
wobei der zweite Umschalter (235b) ausgelegt ist, um in seinem ersten Schaltzustand seinen ersten Eingang (237b) mit dem zweiten Schieberegisterausgang (111b) zu koppeln und um in seinem zweiten Schaltzustand seinen zweiten Eingang (239b) mit dem zweiten Schieberegisterausgang (111b) zu koppeln; und
wobei der zweite Umschalter (235b) so geschaltet ist, dass ein an seinem ersten Eingang (237b) anliegender Pegel auf dem in dem zweiten Latch (201b) vorhandenen Signalzustand basiert und, dass ein an seinem zweiten Eingang (239b) anliegender Pegel unabhängig von dem in dem zweiten Latch (201b) vorhandenen Signalzustand ist.

6. Einer-Aus-Vielen-Auswahlschaltung gemäß Anspruch 5,
wobei Takteingänge der Umschalter (235a, 235b) so geschaltet sind, dass der zweite Umschalter (235b) in seinem zweiten Schaltzustand ist, wenn der erste Umschalter (235a) in seinem ersten Schaltzustand ist und umgekehrt.

7. Einer-Aus-Vielen-Auswahlschaltung gemäß einem der Ansprüche 5 oder 6,
wobei die Umschalter (235a, 235b) taktzustandsgesteuert sind, derart, dass der erste Umschalter (235a) in seinem ersten Schaltzustand ist, wenn ein erster Pegel an seinem Takteingang anliegt und in seinem zweiten Schaltzustand ist, wenn ein zu dem ersten Pegel komplementärer Pegel an dem Takteingang des ersten Umschalters (235a) anliegt und derart, dass der zweite Umschalter (235b) in seinem ersten Schaltzustand ist, wenn ein zweiter Pegel an seinem Takteingang anliegt, und in seinem zweiten Schaltzustand ist, wenn ein zu dem zweiten Pegel komplementärer Pegel an dem Takteingang des zweiten Umschalters (235b) anliegt.

8. Einer-Aus-Vielen-Auswahlschaltung gemäß einem der Ansprüche 1 bis 7,
wobei das zweite Latch (201b) so mit einem dritten Schieberegisterausgang (241) gekoppelt ist, dass ein Pegel an dem dritten Schieberegisterausgang (241) einem Pegel an dem Dateneingang (103 a) des ersten Latches (201 a) nach einer vorgegebenen Anzahl von Taktsignalflanken an einem Taktsignaleingang (113) des Schieberegisters (200) folgt.

9. Einer-Aus-Vielen-Auswahlschaltung gemäß einem der Ansprüche 1 bis 8,
wobei das erste Latch (201a) einen ersten Eingangsschalter (225a) und einen dazu komplementär geschalteten ersten Rückkopplungsschalter (233a) aufweist;
wobei der erste Eingangsschalter (225a) in dem transparenten Betriebszustand des ersten Latches (201a) leitend ist, um den an dem Dateneingang (103a) des ersten Latches (201a) anliegenden Signalzustand zu übernehmen, und in dem nichttransparenten Betriebszustand nicht leitend ist;
wobei der erste Rückkopplungsschalter (233a) in dem nichttransparenten Betriebszustand des ersten Latches (201a) leitend ist, um den von dem Dateneingang (103a) des ersten Latches (201 a) übernommenen Signalzustand in dem ersten Latch (201 a) aufrechtzuerhalten;
wobei das zweite Latch (201b) einen zweiten Eingangsschalter (225b) und einen dazu komplementär geschalteten zweiten Rückkopplungsschalter (233b) aufweist;
wobei der erste Eingangsschalter (225b) in dem transparenten Betriebszustand des zweiten Latches (201b) leitend ist, um den an dem Dateneingang (103b) des zweiten Latches (201b) anliegenden Signalzustand zu übernehmen, und in dem nichttransparenten Betriebszustand des zweiten Latches (201b) nicht leitend ist;
wobei der zweite Rückkopplungsschalter (233b) in dem nichttransparenten Betriebszustand des zweiten Latches (201b) leitend ist, um den von dem Dateneingang (103b) des zweiten Latches (201b) übernommenen Signalzustand in dem zweiten Latch (241b) aufrechtzuerhalten.

10. Einer-Aus-Vielen-Auswahlschaltung gemäß Anspruch 9,
wobei die Schieberegister so ausgelegt sind, dass der erste Eingangsschalter (225a) des ersten Latches (201 a) komplementär zu dem zweiten Eingangsschalter (225b) des zweiten Latches (201b) geschaltet wird, und dass der erste Rückkopplungsschalter (233a) des ersten Latches (201a) komplementär zu dem zweiten Rückkopplungsschalter (233b) des zweiten Latches (201b) geschaltet wird.

11. Einer-Aus-Vielen-Auswahlschaltung gemäß einem der Ansprüche 9 oder 10,
wobei das erste Latch (201a) eine erste Rückkopplungsschleife (227a) aufweist;
wobei die erste Rückkopplungsschleife (227a) hinter dem ersten Eingangsschalter (225a) geschaltet ist und der erste Rückkopplungsschalter (233a) ausgelegt ist, um die erste Rückkopplungsschleife (227a) zu öffnen und zu schließen, um in dem transparenten Betriebszustand des ersten Latches (201 a) bei geöffneter erster Rückkopplungsschleife (227a) den an dem Dateneingang (103a) des ersten Latches (201 a) anliegenden Signalzustand in die erste Rückkopplungsschleife (227a) zu übernehmen und um in dem nichttransparenten Betriebszustand des ersten Latches (201 a) bei geschlossener erster Rückkopplungsschleife (227a) den übernommenen Signalzustand in der ersten Rückkopplungsschleife (227a) aufrechtzuerhalten;
wobei das zweite Latch eine zweite Rückkopplungsschleife (227b) aufweist;
wobei die zweite Rückkopplungsschleife (227b) hinter dem zweiten Eingangsschalter (225b) geschaltet ist und der zweite Rückkopplungsschalter (233b) ausgelegt ist, um die zweite Rückkopplungsschleife (227b) zu öffnen und zu schließen, um in dem transparenten Betriebszustand des zweiten Latches (201b) bei geöffneter zweiter Rückkopplungsschleifer (227a) den an dem Dateneingang (103b) des zweiten Latches (201b) anliegenden Signalzustand in die zweite Rückkopplungsschleife (227b) zu übernehmen und um in dem nichttransparenten Betriebszustand des zweiten Latches (201b) bei geschlossener zweiter Rückkopplungsschleife (227b) den übernommenen Signalzustand in der zweiten Rückkopplungsschleife (227b) aufrechtzuerhalten.

12. Einer-Aus-Vielen-Auswahlschaltung gemäß Anspruch 11,
wobei die erste Rückkopplungsschleife (227a) zumindest zwei in Serie geschaltete Inverter (229a, 231a) aufweist;
wobei der erste Eingangsschalter (225a) mit einem Eingang eines ersten Inverters (229a) der zumindest zwei in Serie geschalteten Inverter (229a, 231 a) der ersten Rückkopplungsschleife (227a) gekoppelt ist;
wobei der erste Rückkopplungsschalter (233a) zwischen einen Ausgang eines letzten Inverters (231 a) der zumindest zwei in Serie geschalteten Inverter (229a, 231a) der ersten Rückkopplungsschleife (227a) und den Eingang des ersten Inverters (229a) der ersten Rückkopplungsschleife (227a) geschaltet ist;
wobei die zweite Rückkopplungsschleife (227b) des zweiten Latches (201b) zumindest zwei in Serie geschaltete Inverter (229b, 231b) aufweist;
wobei der zweite Eingangsschalter (225b) mit einem Eingang eines ersten Inverters (229b) der zumindest zwei in Serie geschalteten Inverter (229b, 231b) der zweiten Rückkopplungsschleife (227b) gekoppelt ist; und
wobei der zweite Rückkopplungsschalter (233b) zwischen einen Ausgang eines letzten Inverters (231 b) der zumindest Serie geschalteten Inverter (229b, 231 b) der zweiten Rückkopplungsschleife (227b) und den Eingang des ersten Inverters (229b) der zweiten Rückkopplungsschleife (227b) geschaltet ist.

13. Einer-Aus-Vielen-Auswahlschaltung gemäß Anspruch 12,
wobei die erste Ausgangsschaltung (107a) mit einem Ausgang des ersten Inverters (229a) der ersten Rückkopplungsschleife (227a) gekoppelt ist, um in dem nichttransparenten Betriebszustand des ersten Latches (201 a) den an dem ersten Schieberegisterausgang (111a) bereitgestellten Pegel in Abhängigkeit von einem Pegel an dem Ausgang des ersten Inverters (229a) der ersten Rückkopplungsschleife (227a) bereitzustellen.

14. Bildsensor mit einer Einer-Aus-Vielen-Auswahlschaltung gemäß einem der Ansprüche 1 bis 13.

15. Multiplexer mit einer Einer-Aus-Vielen-Auswahlschaltung gemäß einem der Ansprüche 1 bis 13.

## Claims

1. A one-of-many selection circuit comprising a one-of-many shift register (300) comprising a data input (301) and a clock input (303), the one-of-many shift register (300) comprising:
a plurality of series-connected shift registers (100; 200; 200a - 200n), comprising:
a first latch (101a; 201a) which is implemented to take over a signal state applied to its data input (103a) in a transparent operating state and to maintain the taken-over signal state in a non-transparent operating state;
a second latch (101b; 201 b) which is implemented to take over a signal state applied to its data input (103b) in a transparent operating state and to maintain the taken-over signal state in a non-transparent operating state;
wherein the first latch (101a; 201a) and the second latch (101b; 201b) are series-connected;
wherein clock inputs (105a, 105b) of the latches (101a, 101b; 201a, 201b) are switched such that the second latch (101b; 201b) is in the transparent operating state when the first latch (101a; 201a) is in the non-transparent operating state and vice versa;
a first output circuit (107a, 207a) which is implemented to provide a predetermined level independent of the signal state existing in the first latch (101a; 201a) at a first shift register output (111a) of the shift register (100, 200; 200a - 200n) in the transparent operating state of the first latch (101a; 201 a) and to provide a level depending on the signal state stored in the first latch (101a; 201a) in the non-transparent operating state of the first latch (101a; 201a); and
a second output circuit (107b, 207b) which is implemented to provide a predetermined level independent of the signal state existing in the second latch (101b; 201b) at a second shift register output (111b) of the shift register (100, 200, 200a - 200n) in the transparent operating state of the second latch (101b, 201b) and to provide a level depending on the signal state stored in the second latch (101b, 201b) in the non-transparent operating state of the second latch (101b; 201 b);
wherein the shift registers (200a - 200n) are coupled to the data input (301) and the clock input (303) such that a "1" applied to the data input (301) is shifted through the shift registers (200a - 200n) such that with a falling clock edge at the clock input (303) the "1" is shifted on from a first shift register output (O0) of a first shift register (200a) of the plurality of shift registers (200a - 200n) to a second shift register output (O1) of the same shift register (200a) and that with a rising clock edge the "1" is shifted on from the second shift register output (O1) of the first shift register (200a) to a first shift register output (02) of a subsequent shift register (200b);
or that with a rising clock edge at the clock input (303) the "1" is shifted on from a first shift register output (O0) of a first shift register (200a) of the plurality of shift registers (200a - 200n) to a second shift register output (O1) of the same shift register (200a) and that with a falling clock edge the "1" is shifted on from the second shift register output (O1) of the first shift register (200a) to a first shift register output (02) of a subsequent shift register (200b).

2. A one-of-many selection circuit according to claim 1,
wherein the clock inputs (105a, 105b) of the two latches (101a, 101b, 201a, 201b) are switched invertedly such that, when a first level is applied to the clock input (105a) of the first latch (101a, 201a), a level complementary to the first level is applied to the clock input (105b) of the second latch (101b, 201b).

3. A one-of-many selection circuit according to any of claims 1 or 2,
wherein clock inputs (117a, 117b) of the output circuits (107a, 107b, 207a, 207b) are switched invertedly such that, when a first level is applied to a clock input (117a) of the first output circuit (107a, 207a), a level complementary to the first level is applied to a clock input (117b) of the second output circuit (107b, 207b).

4. A one-of-many selection circuit according to any of claims 1 to 3,
wherein a clock input (113) of the shift registers (100, 200) is coupled to the clock inputs (105a, 105b) of the latches (101 a, 101 b, 201 a, 201 b) and to the clock inputs (117a, 117b) of the output circuits (107a, 107b, 207a, 207b), such that in response to a clock state change at the clock input (113) of the shift registers (100, 200) both the operating states of the latches (101a, 101b, 201a, 201b) and also the switching states of the output circuits (107a, 107b, 207a, 207b) change.

5. A one-of-many selection circuit according to any of claims 1 to 4,
wherein the first output circuit (207a) comprises a first changeover switch (235a) with a first input (237a) and a second input 239a);
wherein the first changeover switch (235a) is implemented, in its first switching state, to couple its first input (237a) to the first shift register output (111a) and, in its second switching state, to couple its second input (239a) to the first shift register output (111a);
wherein the first changeover switch (235a) is switched such that a level applied to its first input (237a) is based on the signal state existing in the first latch (201a) and that a level applied to its second input (239a) is independent of the signal state existing in the first latch (201 a);
wherein the second output circuit (207b) comprises a second changeover switch (235b) with a first input (237b) and a second input (239b);
wherein the second changeover switch (235b) is implemented, in its first switching state, to couple its first input (237b) to the second shift register output (111b) and, in its second switching state, to couple its second input (239b) to the second shift register output (111 b); and
wherein the second changeover switch (235b) is switched such that a level applied to its first input (237b) is based on the signal state existing in the second latch (201b) and that a level applied to its second input (239b) is independent of the signal state existing in the second latch (201 b).

6. A one-of-many selection circuit according to claim 5,
wherein clock inputs of the changeover switches (235a, 235b) are switched such that the second changeover switch (235b) is in its second switching state when the first changeover switch (235a) is in its first switching state and vice versa.

7. A one-of-many selection circuit according to any of claims 5 or 6,
wherein the changeover switches (235a, 235b) are clock state controlled such that the first changeover switch (235a) is in its first switching state when a first level is applied to its clock input and is in its second switching state when a level complementary to the first level is applied to the clock input of the first changeover switch (235a) and such that the second changeover switch (235b) is in its first switching state when a second level is applied to its clock input and is in its second switching state when a level complementary to the second level is applied to the clock input of the second changeover switch (235b).

8. A one-of-many selection circuit according to any of claims 1 to 7,
wherein the second latch (201 b) is coupled to a third shift register output (241) such that a level at the third shift register output (241) follows a level at the data input (103a) of the first latch (201a) after a predetermined number of clock signal edges at a clock signal input (113) of the shift register (200).

9. A one-of-many selection circuit according to any of claims 1 to 8,
wherein the first latch (201 a) comprises a first input switch (225a) and a first feedback switch (233a) switched complementarily with respect to the same;
wherein the first input switch (225a) is conductive in the transparent operating state of the first latch (201 a) to take over the signal state applied to the data input (103a) of the first latch (201a) and is not conductive in the non-transparent operating state;
wherein the first feedback switch (233a) is conductive in the non-transparent operating state of the first latch (201 a) to maintain the signal state taken over from the data input (103a) of the first latch (201 a) in the first latch (201 a);
wherein the second latch (201 b) comprises a second input switch (225b) and a second feedback switch (233b) which is switched complementarily to the same;
wherein the first input switch (225b) is conductive in the transparent operating state of the second latch (201 b) to take over the signal state applied to the data input (103b) of the second latch (201b) and is not conductive in the non-transparent operating state of the second latch (201 b);
wherein the second feedback switch (233b) is conductive in the non-transparent operating state of the second latch (201 b) to maintain the signal state taken over from the data input (103b) of the second latch (201 b) in the second latch (201 b).

10. A one-of-many selection circuit according to claim 9,
wherein the shift registers are implemented such that the first input switch (225a) of the first latch (201 a) is switched complementarily to the second input switch (225b) of the second latch (201 b) and that the first feedback switch (233a) of the first latch (201 a) is switched complementarily to the second feedback switch (233b) of the second latch (201b).

11. A one-of-many selection circuit according to any of claims 9 or 10,
wherein the first latch (201a) comprises a first feedback loop (227a);
wherein the first feedback loop (227a) is connected behind the first input switch (225a) and the first feedback switch (233a) is implemented to open and close the first feedback loop (227a) to take over the signal state applied to the data input (103a) of the first latch (201 a) into the first feedback loop (227a) in the transparent operating state of the first latch (201 a) with an opened first feedback loop (227a) and to maintain the taken-over signal state in the first feedback loop (227a) in the non-transparent operating state of the first latch (201a) with a closed first feedback loop (227a);
wherein the second latch comprises a second feedback loop (227b);
wherein the second feedback loop (227b) is connected behind the second input switch (225b) and the second feedback switch (233b) is implemented to open and close the second feedback loop (227b) to take over the signal state applied to the data input (103b) of the second latch (201 b) into the second feedback loop (227b) in the transparent operating state of the second latch (201 b) with an opened second feedback loop (227a) and to maintain the taken-over signal state in the second feedback loop (227b) in the non-transparent operating state of the second latch (201 b) with a closed second feedback loop (227b).

12. A one-of-many selection circuit according to claim 11,
wherein the first feedback loop (227a) comprises at least two series-connected inverters (229a, 231 a);
wherein the first input switch (225a) is coupled to an input of a first inverter (229a) of the at least two series-connected inverters (229a, 231 a) of the first feedback loop (227a);
wherein the first feedback switch (233a) is connected between an output of a last inverter (231a) of the at least two series-connected inverters (229a, 231a) of the first feedback loop (227a) and the input of the first inverter (229a) of the first feedback loop (227a);
wherein the second feedback loop (227b) of the second latch (201 b) comprises at least two series-connected inverters (220b, 231 b);
wherein the second input switch (225b) is coupled to an input of a first inverter (229b) of the at least two series-connected inverters (229b, 231 b) of the second feedback loop (227b); and
wherein the second feedback switch (233b) is connected between an output of a last inverter (231 b) of the at least two series-connected inverters (229b, 231 b) of the second feedback loop (227b) and the input of the first inverter (229b) of the second feedback loop (227b).

13. A one-of-many selection circuit according to claim 12,
wherein the first output circuit (107a) is coupled to an output of the first inverter (229a) of the first feedback loop (227a) to provide the level provided at the first shift register output (111a) in the non-transparent operating state of the first latch (201 a) depending on a level at the output of the first inverter (229a) of the first feedback loop (227a).

14. An image sensor having a one-of-many selection circuit according to any of claims 1 to 13.

15. A multiplexer having a one-of-many selection circuit according to any of claims 1 to 13.

## Revendications

1. Circuit de sélection d'un parmi d'autres avec un registre à décalage d'un parmi d'autres (300) avec une entrée de données (301) et une entrée d'horloge (303), dans lequel le registre à décalage d'un parmi d'autres (300) présente les caractéristiques suivantes:
une pluralité de registres à décalage connectés en série (100; 200; 200a à 200n), aux caractéristiques suivantes:
un premier verrou (101a; 201a) qui est conçu pour adopter, dans un mode de fonctionnement transparent, un état de signal présent à son entrée de données (103a) et pour maintenir, dans un mode de fonctionnement non transparent, l'état de signal adopté;
un deuxième verrou (101b; 201b) qui est conçu pour adopter, dans un mode de fonctionnement transparent, un état de signal présent à son entrée de données (103b) et pour maintenir, dans un mode de fonctionnement non transparent, l'état de signal adopté;
dans lequel le premier verrou (101a; 201a) et le deuxième verrou (101b; 201b) sont connectés en série;
dans lequel les entrées d'horloge (105a, 105b) des verrous (101a, 101b; 201a, 201b) sont connectées de sorte que le deuxième verrou (101b; 201b) se trouve dans l'état de fonctionnement transparent lorsque le premier verrou (101a; 201a) se trouve dans le mode de fonctionnement non transparent, et inversement;
un premier circuit de sortie (107a, 207a) qui est conçu pour mettre à disposition, à une première sortie (111a) du registre à décalage (100, 200; 200a à 200n), dans l'état de fonctionnement transparent du premier verrou (101a ; 201a), un niveau prédéterminé indépendant de l'état de signal présent dans le premier verrou (101a; 201a) et pour mettre à disposition, dans l'état de fonctionnement non transparent du premier verrou (101a ; 201a), un niveau dépendant de l'état de signal mémorisé dans le premier verrou (101a ; 201a); et
un deuxième circuit de sortie (107b, 207b) qui est conçu pour mettre à disposition, à une deuxième sortie (111b) du registre à décalage (100, 200, 200a à 200n), dans l'état de fonctionnement transparent du deuxième verrou (101b, 201b), un niveau prédéterminé indépendant de l'état de signal présent dans le deuxième verrou (101b, 201b) et pour mettre à disposition, dans l'état de fonctionnement non transparent du deuxième verrou (101b, 201b), un niveau dépendant de l'état de signal mémorisé dans le deuxième verrou (101b, 201 b);
dans lequel les registres à décalage (200a à 200n) sont couplés à l'entrée de données (301) et à l'entrée d'horloge (303) de sorte qu'un "1" présent à l'entrée de données (301) soit déplacé à travers les registres à décalage (200a à 200n), de sorte que, en cas de flanc d'horloge tombant à l'entrée d'horloge (303), le "1" soit avancé d'une première sortie (O0) d'un premier registre à décalage (200a) de la pluralité de registres à décalage (200a à 200n) vers une deuxième sortie (O1) du même registre à décalage (200a) et que, en cas de flanc d'horloge montant, le "1" soit avancé de la deuxième sortie (O1) du premier registre à décalage (200a) vers une première sortie (02) d'un registre à décalage suivant (200b);
ou que, en cas de flanc d'horloge montant à l'entrée d'horloge (303), le "1" soit avancé d'une première sortie (O0) d'un premier registre à décalage (200a) de la pluralité de registres à décalage (200a à 200n) vers une deuxième sortie (O1) du même registre à décalage (200a) et que, en cas de flanc d'horloge tombant, le "1" soit avancé de la deuxième sortie (O1) du premier registre à décalage (200a) vers une première sortie (02) d'un registre à décalage suivant (200b).

2. Circuit de sélection d'un parmi d'autres selon la revendication 1,
dans lequel les entrées d'horloge (105a, 105b) des deux verrous (101a, 101b, 201a, 201b) sont connectées de manière inversée, de sorte que, lorsqu'à l'entrée d'horloge (105a) du premier verrou (101a, 201a) est présent un premier niveau, à l'entrée d'horloge (105b) du deuxième verrou (101b, 201b) soit présent un niveau complémentaire au premier niveau.

3. Circuit de sélection d'un parmi d'autres selon l'une des revendications 1 ou 2,
dans lequel les entrées d'horloge (117a, 117b) des circuits de sortie (107a, 107b, 207a, 207b) sont connectées de manière inversée, de sorte que, lorsqu'à une entrée d'horloge (117a) du premier circuit de sortie (107a, 207a) est présent un premier niveau, un niveau complémentaire au premier niveau est présent à une entrée d'horloge (117b) du deuxième circuit de sortie (107b, 207b).

4. Circuit de sélection d'un parmi d'autres selon l'une des revendications 1 à 3,
dans lequel une entrée d'horloge (113) du registre à décalage (100, 200) est couplée aux entrées d'horloge (105a, 105b) des verrous (101a, 101b, 201a, 201b) et aux entrées d'horloge (117a, 117b) des circuits de sortie (107a, 107b, 207a, 207b), de sorte que changent, en réaction à un changement d'état d'horloge à l'entrée d'horloge (113) des registres à décalage (100, 200), tant les états de fonctionnement des verrous (101a, 101b, 201a, 201b) que les états de commutation des circuits de sortie (107a, 107b, 207a, 207b).

5. Circuit de sélection d'un parmi d'autres selon l'une des revendications 1 à 4,
dans lequel le premier circuit de sortie (207a) présente un premier commutateur (235a) avec une première entrée (237a) et une deuxième entrée (239a);
dans lequel le premier commutateur (235a) est conçu pour coupler, dans son premier état de commutation, sa première entrée (237a) à la première sortie de registre à décalage (111a) et pour coupler, dans son deuxième état de commutation, sa deuxième entrée (239a) à la première sortie de registre à décalage (111a);
dans lequel le premier commutateur (235a) est commuté de sorte qu'un niveau présent à sa première entrée (237a) se base sur l'état de signal présent dans le premier verrou (201a), et qu'un niveau présent à sa deuxième entrée (239a) soit indépendant de l'état de signal présent dans le premier verrou (201a);
dans lequel le deuxième circuit de sortie (207b) présente un deuxième commutateur (235b) avec une première entrée (237b) et une deuxième entrée (239b);
dans lequel le deuxième commutateur (235b) est conçu pour coupler, dans son premier état de commutation, sa première entrée (237b) à la deuxième sortie de registre à décalage (111b) et pour coupler, dans son deuxième état de commutation, sa deuxième entrée (239b) à la deuxième sortie de registre à décalage (111b); et
dans lequel le deuxième commutateur (235b) est commuté de sorte qu'un niveau présent à sa première entrée (237b) se base sur l'état de signal présent dans le deuxième verrou (201b) et qu'un niveau présent à sa deuxième entrée (239b) soit indépendant de l'état de signal présent dans le deuxième verrou (201b).

6. Circuit de sélection d'un parmi d'autres selon la revendication 5,
dans lequel les entrées d'horloge des commutateurs (235a, 235b) sont connectées de sorte que le deuxième commutateur (235b) se trouve dans son deuxième état de commutation lorsque le premier commutateur (235a) se trouve dans son premier état de commutation, et inversement.

7. Circuit de sélection d'un parmi d'autres selon l'une des revendications 5 ou 6,
dans lequel les commutateurs (235a, 235b) sont commandés par l'état d'horloge, de sorte que le premier commutateur (235a) se trouve dans son premier état de commutation lorsqu'un premier niveau est présent à son entrée d'horloge et soit dans son deuxième état de commutation lorsqu'un niveau complémentaire au premier niveau est présent à l'entrée d'horloge du premier commutateur (235a) et de sorte que le deuxième commutateur (235b) se trouve dans son premier état de commutation lorsqu'un deuxième niveau est présent à son entrée d'horloge, et se trouve dans son deuxième état de commutation lorsqu'un niveau complémentaire au deuxième niveau est présent à l'entrée d'horloge du deuxième commutateur (235b).

8. Circuit de sélection d'un parmi d'autres selon l'une des revendications 1 à 7,
dans lequel le deuxième verrou (201b) est couplé à une troisième sortie de registre à décalage (241) de sorte qu'un niveau à la troisième sortie de registre à décalage (241) suive un niveau à l'entrée de données (103a) du premier verrou (201a) après un nombre prédéterminé de flancs de signal d'horloge à une entrée de signal d'horloge (113) du registre à décalage (200).

9. Circuit de sélection d'un parmi d'autres selon l'une des revendications 1 à 8,
dans lequel le premier verrou (201a) présente un premier commutateur d'entrée (225a) et un premier commutateur de couplage rétroactif (233a) y connecté de manière complémentaire;
dans lequel le premier commutateur d'entrée (225a) est conducteur dans le mode de fonctionnement transparent du premier verrou (201a), pour adopter l'état de signal présent à l'entrée de données (103a) du premier verrou (201a), et n'est pas conducteur dans le mode de fonctionnement non transparent;
dans lequel le premier commutateur de couplage rétroactif (233a) est conducteur dans le mode de fonctionnement non transparent du premier verrou (201a), pour maintenir l'état de signal adopté de l'entrée de données (103a) du premier verrou (201a) dans le premier verrou (201a);
dans lequel le deuxième verrou (201 b) présente un deuxième commutateur d'entrée (225b) et un deuxième commutateur de couplage rétroactif (233b) y connecté de manière complémentaire;
dans lequel ledit premier commutateur d'entrée (225b) est conducteur dans le mode de fonctionnement transparent du deuxième verrou (201b), pour adopter l'état de signal présent à l'entrée de données (103b) du deuxième verrou (201b), et n'est pas conducteur dans le mode de fonctionnement non transparent du deuxième verrou (201b);
dans lequel le deuxième commutateur de couplage rétroactif (233b) est conducteur dans le mode de fonctionnement non transparent du deuxième verrou (201 b), pour maintenir l'état de signal adopté de l'entrée de données (103b) du deuxième verrou (201b) dans le deuxième verrou (201b).

10. Circuit de sélection d'un parmi d'autres selon la revendication 9, dans lequel les registres à décalage sont conçus de sorte que le premier commutateur d'entrée (225a) du premier verrou (201a) soit connecté de manière complémentaire au deuxième commutateur d'entrée (225b) du deuxième verrou (201b), et que le premier commutateur de couplage rétroactif (233a) du premier verrou (201a) soit commuté de manière complémentaire au deuxième commutateur de couplage rétroactif (233b) du deuxième verrou (201b).

11. Circuit de sélection d'un parmi d'autres selon l'une des revendications 9 ou 10,
dans lequel le premier verrou (201a) présente une première boucle de couplage rétroactif (227a);
dans lequel la première boucle de couplage rétroactif (227a) est connectée derrière le premier commutateur d'entrée (225a) et le premier commutateur de couplage rétroactif (233a) est conçu pour ouvrir et fermer la première boucle de couplage rétroactif (227a), pour adopter dans la première boucle de couplage rétroactif (227a), dans le mode de fonctionnement transparent du premier verrou (201a), à première boucle de couplage rétroactif (227a) ouverte, l'état de signal présent à l'entrée de données (103a) du premier verrou (201a) et pour maintenir dans la première boucle de couplage rétroactif (227a), dans le mode de fonctionnement non transparent du premier verrou (201a), l'état de signal adopté à première boucle de couplage rétroactif (227a) fermée;
dans lequel le deuxième verrou présente une deuxième boucle de couplage rétroactif (227b);
dans lequel la deuxième boucle de couplage rétroactif (227b) est connectée derrière le deuxième commutateur d'entrée (225b) et le deuxième commutateur de couplage rétroactif (233b) est conçu pour ouvrir et fermer la deuxième boucle de couplage rétroactif (227b) pour adopter dans la deuxième boucle de couplage rétroactif (227a), dans le mode de fonctionnement transparent du deuxième verrou (201b), à deuxième boucle de couplage rétroactif (227b) ouverte, l'état de signal présent à l'entrée de données (103b) du deuxième verrou (201b) et pour maintenir dans la deuxième boucle de couplage rétroactif (227b), dans le mode de fonctionnement non transparent du deuxième verrou (201), l'état de signal adopté à deuxième boucle de couplage rétroactif (227b) fermée.

12. Circuit de sélection d'un parmi d'autres selon la revendication 11,
dans lequel la première boucle de couplage rétroactif (227b) présente au moins deux inverseurs (229a, 231a) connectés en série;
dans lequel le premier commutateur d'entrée (225a) est couplé à une entrée d'un premier inverseur (229a) des au moins deux inverseurs (229a, 231a) connectés en série de la première boucle de couplage rétroactif (227b);
dans lequel le premier commutateur de couplage rétroactif (233a) est connecté entre une sortie d'un dernier inverseur (231a) des au moins deux inverseurs (229a, 231a) connectés en série de la première boucle de couplage rétroactif (227a) et l'entrée du premier inverseur (229a) de la première boucle de couplage rétroactif (227a);
dans lequel la deuxième boucle de couplage rétroactif (227b) du deuxième verrou (201b) présente au moins deux inverseurs (229b, 231b) connectés en série;
dans lequel le deuxième commutateur d'entrée (225b) est couplé à une entrée d'un premier inverseur (229b) des au moins deux inverseurs (229b, 231b) connectés en série de la deuxième boucle de couplage rétroactif (227b); et
dans lequel le deuxième commutateur de couplage rétroactif (233b) est connecté entre une sortie d'un dernier inverseur (231b) des au moins deux inverseurs (229b, 231b) connectés en série de la deuxième boucle de couplage rétroactif (227b) et l'entrée du premier inverseur (229b) de la deuxième boucle de couplage rétroactif (227b).

13. Circuit de sélection d'un parmi d'autres selon la revendication 12,
dans lequel le premier circuit de sortie (107a) est couplé à une sortie du premier inverseur (229a) de la première boucle de couplage rétroactif (227a), pour mettre à disposition, dans le mode de fonctionnement non transparent du premier verrou (201a), le niveau mis à disposition à la sortie de registre à décalage (111a) en fonction d'un niveau à la sortie du premier inverseur (229a) du premier verrou de couplage rétroactif (227a).

14. Capteur d'images avec un circuit de sélection d'un parmi d'autres selon l'une des revendications 1 à 13.

15. Multiplexeur avec un circuit de sélection d'un parmi d'autres selon l'une des revendications 1 à 13.
